# EUROPEAN PATENT APPLICATION

(11) **EP 2 360 735 A1**
(43) Date of publication of application: **24.08.2011**
(21) Application number: 09828886.3
(22) Date of filing: 27.11.2009
(51) Int. Cl.: H01L 31/042, G02B 5/04, G02B 5/08, H01L 31/052

(54) **OPTICAL LAYER FOR A LIGHT-ADJUSTING TYPE SOLAR POWER-GENERATING MODULE, LIGHT-ADJUSTING TYPE SOLAR POWER-GENERATING MODULE AND LIGHT-ADJUSTING TYPE SOLAR POWER-GENERATING PANEL**

(30) Priority: 27.11.2008 JP 2008302554
(71) Applicant: Nippon Carbide Industries Co., Inc., Minato-ku, Tokyo 108-8466 (JP)
(72) Inventor: MIMURA, Ikuo, Uozu-city Toyama 973-0061 (JP); AMEMIYA, Keiji, Namerikawa-city Toyama 936-0807 (JP); SANAGAWA, Masatoshi, Machida-city Tokyo 194-0044 (JP)
(74) Representative: HOFFMANN EITLE
(86) International application number: PCT/JP2009/006451
(87) International publication number: WO 2010/061636

(57) **Abstract**

An optical layer for a light control type solar photovoltaic module, a light control type solar photovoltaic module, and a light control type solar photovoltaic panel having an excellent directionality to the sunlight are provided.

An optical layer 4 for a light control type solar photovoltaic module includes an entrance surface 11 and an exit surface 12 and is arranged opposite photovoltaic cells 6 that convert light into electric energy. A number of prismatic optical elements are formed in at least one of the entrance surface 11 and the exit surface 12, each of the prismatic optical elements is on a common plane S1 defined by a common base shared by the prismatic optical elements adjacent to each other, and a prism axis 7 of each of the prismatic optical elements is inclined toward a predetermined direction with respect to a direction perpendicular to the common plane.

## Description

### Technical Field

The present invention relates to an optical layer for a light control type solar photovoltaic module, a light control type solar photovoltaic module, and a light control type solar photovoltaic panel.

More particularly, the invention relates to an optical layer for a light control type solar photovoltaic module, a light control type solar photovoltaic module, and a light control type solar photovoltaic panel with an improved directionality to the sunlight and an improved installation area.

### Background Art

A solar photovoltaic panel generally has a non-concentrating and fixed structure that is installed in a state in which a solar photovoltaic module in which photovoltaic cells are closely arrayed is installed on a roof or the ground so that a panel surface is oriented toward the south, for example. In this case, the solar photovoltaic panel surface is oriented toward the south and inclined such that light-receiving efficiency of the sunlight becomes the maximum.

Such a conventionally known solar photovoltaic panel needs to be installed in an inclined state. Therefore, the conventionally known solar photovoltaic panel has a problem that a relatively large installation area is required and the installation site is restricted, which does not satisfy improvement of installation area.

Moreover, the conventionally known solar photovoltaic panel has a problem that the directionality to the sunlight is poor owing to the fact that a direction or an inclination angle of the installed solar photovoltaic panel are not always optimum due to movement of the sun during the day, a change in culmination altitude from season to season and the like.

On the other hand, in order to reduce a use amount of the photovoltaic cells accounting for a large proportion of cost for the solar photovoltaic device, there are proposed various light concentrating solar photovoltaic panels in which the sunlight is collected onto small photovoltaic cells using optical systems such as lenses and reflecting mirrors.

However, there is no proposal as to what optical system has excellent improvement of installation area and directionality to the sunlight in these concentrating solar photovoltaic panels.

There is also proposed a concentrating and tracking solar photovoltaic panel in which the sunlight is collected onto photovoltaic cells using optical systems such as lenses and reflecting mirrors and the optical systems track the sun such that the sunlight is always focused on the photovoltaic cells.

Such a concentrating and tracking solar photovoltaic panel has an excellent directionality to the sunlight. However, the concentrating and tracking solar photovoltaic panel has a problem that production cost increases and the installation area is also enlarged because of an extensive tracking system is required.

Japanese Patent Application Laid-Open No. 2007-073774 (Patent Document 1) by Minakata et al. discloses a solar cell including a photoelectric conversion element that converts photo energy of light received by a light-receiving surface into electric energy, external-light deflection means for deflecting incident external light such that the light have enhanced directionality in a predetermined direction, and light collection means that includes an entrance surface to which the light deflected by the external-light deflection means is incident and collects the light incident to the entrance surface onto the light-receiving surface of the photoelectric conversion element.

Japanese Patent Application Laid-Open No. 2006-332113 by Yasuzawa et al. discloses a concentrating solar photovoltaic module including a primary optical system that collects the sunlight, a secondary optical system that collects the sunlight output from the primary optical system and irradiates a photovoltaic cell with the sunlight, and the photovoltaic cell that receives the sunlight output from the primary optical system and the secondary optical system, wherein the secondary optical system has an opening.

US 5,167,724 (Patent Document 3) by Chiang discloses a planar solar photovoltaic module including a housing having a front wall and a rear wall, which form a space, and a photovoltaic cell provided in the space. In the planar solar photovoltaic module, a lens is provided as the front wall of the housing such that the sunlight enters the housing. Patent Document 3 also discloses an optical refraction element that is provided opposite the lens in contact with the photovoltaic cell. The optical refraction element directly receives the sunlight entering the housing through the lens and supplies the sunlight to the photovoltaic cell such that the photovoltaic cell can generate power.

Japanese Patent Application Laid-Open No. 2002-289897 (Patent Document 4) by Sasaoka discloses a concentrating solar photovoltaic module including a primary optical system having a rectangular entrance surface and a secondary optical system having an entrance surface to which solar beam collected by the primary optical system is substantially totally incident, a lateral surface by which solar beam is totally reflected and an exit surface through which solar beam exits. The lateral surface of the secondary optical system is made of a smooth and solid transparent material having an even medium, includes the rectangular exit surface, and includes at least a photovoltaic element immediately behind the rectangular exit surface.

Japanese Patent Application Laid-Open No. 2003-258291 (Patent Document 5) by Sasaoka discloses a concentrating solar photovoltaic device including a Fresnel lens arranged in a state in which an optical axis is oriented toward the sunlight, a solar cell, a prism secondary light collector having a low-order polygonal section. The prism secondary light collector is provided between the Fresnel lens and the solar cell. A light flux collected by the Fresnel lens is incident to the prism secondary light collector, and the prism secondary light collector reflects the light flux to guide the light flux to the solar cell.

### Citation List

### Patent Documents

[Patent Document 1] Japanese Patent Application Laid-Open No. 2007-073774
[Patent Document 2] Japanese Patent Application Laid-Open No. 2006-332113
[Patent Document 3] US Patent No. 5,167,724
[Patent Document 4] Japanese Patent Application Laid-Open No. 2002-289897
[Patent Document 5] Japanese Patent Application Laid-Open No. 2003-258291

### Summary of the Invention

### Objects to be Achieved by the Invention

It is an object to be achieved by the invention to solve the problems that the conventionally known solar photovoltaic panels need to be installed at a large inclination angle so as to be aligned with the altitude of the sun, and thus the relatively large installation area is required and the installation site is restricted, which does not satisfy improvement in the installation area. Therefore, the invention is made to solve the problems.

In addition, it is an object to be solved by the invention to improve the problems that the conventionally known solar photovoltaic panels do not have an excellent directionality to the sunlight because the direction or inclination angle of an installed solar photovoltaic panel is not always optimum due to the movement of the sun during the day, a change in culmination altitude from season to season and the like.

Moreover, it is an object to be solved by the invention to reduce the use amount of the photovoltaic cells accounting for a large proportion of raw material cost in a solar photovoltaic panel.

Specifically, embodiments of the invention can be applied to an optical layer for a light control type solar photovoltaic module that can provide a light control type solar photovoltaic panel having an improved directionality to the sunlight and an improved installation area, a light control type solar photovoltaic module in which the optical layer for a light control type solar photovoltaic module is used, and a light control type solar photovoltaic panel.

### Means for Achieving the Objects

An optical layer for a light control type solar photovoltaic module according to an embodiment of the invention includes an entrance surface and an exit surface and is arranged opposite a photovoltaic cell that converts light into electric energy, wherein a number of prismatic optical elements are formed in at least one of the entrance surface and the exit surface, each of the prismatic optical elements is on a common plane defined by a common base shared by the prismatic optical elements adjacent to each other, and a prism axis of each of the prismatic optical elements is inclined toward a predetermined direction with respect to a direction perpendicular to the common plane.

As used herein, a prism axis means a surface or a line that constitutes the center of prism surfaces forming a prismatic optical element.

Conventionally, a light control type solar photovoltaic panel having a light control type solar photovoltaic module including an optical layer, that controls the sunlight and photovoltaic cells that converts the sunlight transmitted through the optical layer into electric energy is well known as a concentrating solar photovoltaic panel.

However, it is not known, in a concentrating solar photovoltaic panel in which such an optical layer is provided, what optical elements provided in the optical layer make the optical layer exhibit an excellent installation area improvement and directionality to the sunlight.

According to the optical layer for a light control type solar photovoltaic module of the embodiment of the invention, each of the prismatic optical elements is on a common plane defined by the common base shared by the prismatic optical elements adjacent to each other, and the prism axis of each of the prismatic optical elements is inclined toward the predetermined direction with respect to the direction perpendicular to the common plane. Accordingly, by installing a solar photovoltaic module or the like in which the optical layer for a light control type solar photovoltaic module is used such that the predetermined direction is oriented upward, an excellent directionality to the sunlight can be obtained.

Preferably, in the optical layer for a light control type solar photovoltaic module described above, a number of prismatic optical elements are formed such that prism axes thereof are inclined toward a predetermined direction at a plurality of angles.

With this configuration, even if the altitude of the sun changes from season to season, an solar photovoltaic module or the like in which the optical layer for a light control type solar photovoltaic module of the embodiment is used can have an excellent directionality to the sunlight.

Preferably, in the optical layer for a light control type solar photovoltaic module described above, the prismatic optical elements are one of linear prisms, triangular pyramid prisms, square pyramid prisms, and cube corner prisms or a combination thereof, so as to obtain an improved directionality to the sunlight.

Among others, the cube corner prisms are preferable because of the cube corner prisms have a large improvement effect of the directionality to the sunlight. Preferably, in the optical layer for a light control type solar photovoltaic module described above, bases of all the prismatic optical elements are formed on the common plane. With this configuration, because all the elements are formed on the common plane, the optical layer for a light control type solar photovoltaic module can be thinned.

Alternatively, in the optical layer for a light control type solar photovoltaic module described above, it is also preferable that some bases of the prismatic optical elements be formed out of the common plane. With this configuration, areas of the prism surfaces opposite to each other can be brought close to each other, and an amount of light incident to the cell can be increased.

Preferably, in the optical layer for a light control type solar photovoltaic module described above, the prismatic optical elements are formed in both the entrance surface and the exit surface. With this configuration, the entrance efficiency and the transmission efficiency can be improved.

In the optical layer for a light control type solar photovoltaic module described above, the prismatic optical elements may be formed such that the prismatic optical elements formed in the entrance surface and the prismatic optical elements formed in the exit surface have identical shapes and such that phases of the prismatic optical elements are matched with each other between the entrance surface and the exit surface.

Alternatively, in the optical layer for a light control type solar photovoltaic module described above, the prism axes of the prismatic optical elements formed in the entrance surface may differ in shape from the prism axes of the prismatic optical elements formed in the exit surface.

Preferably, in the optical layer for a light control type solar photovoltaic module described above, the prismatic optical elements are formed only in one of the entrance surface and the exit surface while the other surface is formed flat. With this configuration, the entrance efficiency and the transmission efficiency can be improved.

The material for the optical layer that can be used in embodiments of the invention is not particularly limited as long as the material has a high light transmission characteristic. However, preferably the optical layer for a light control type solar photovoltaic module described above is made of glass, transparent resin, or a laminated body thereof. Preferable examples of the glass include soda-lime glass, borosilicate glass, lead glass, aluminosilicate glass, borate glass, and phosphate glass. Preferable examples of the transparent resin include a polycarbonate resin and an acrylic resin. With this configuration, the optical layer for a light control type solar photovoltaic module can have excellent weather resistance, transparency, entrance efficiency, and light transmission efficiency.

A light control type solar photovoltaic module according to an embodiment of the invention includes a photovoltaic cell that converts light into electric energy; and an optical layer for a light control type solar photovoltaic module that includes an entrance surface and an exit surface and is arranged opposite the photovoltaic cell, wherein in the optical layer for a light control type solar photovoltaic module, a number of prismatic optical elements are formed in at least one of the entrance surface and the exit surface, each of the prismatic optical elements is on a common plane defined by a common base shared by the prismatic optical elements adjacent to each other, and a prism axis of each of the prismatic optical elements is inclined toward a predetermined direction with respect to a direction perpendicular to the common plane. By installing the optical layer for a light control type solar photovoltaic module such that the predetermined direction is oriented upward, an excellent directionality to the sunlight can be obtained.

A solar photovoltaic panel according to an embodiment of the invention includes a light control type solar photovoltaic module including a photovoltaic cell that converts light into electric energy and an optical layer for a light control type solar photovoltaic module that includes an entrance surface and an exit surface and is arranged opposite the photovoltaic cell, wherein in the optical layer for a light control type solar photovoltaic module, a number of prismatic optical elements are formed in at least one of the entrance surface and the exit surface, each of the prismatic optical elements is on a common plane defined by a common base shared by the prismatic optical elements adjacent to each other, and a prism axis of each of the prismatic optical elements is inclined toward a predetermined direction with respect to a direction perpendicular to the common plane.

By installing the light control type solar photovoltaic panel such that the predetermined direction is oriented upward, an excellent directionality to the sunlight can be obtained.

Preferably, in the light control type solar photovoltaic panel described above, the entrance surface of the optical layer for a light control type solar photovoltaic module is oriented to a sun direction at noon.

As used herein, the sun direction at noon means a direction at the time the sun reaches the highest latitude, and the sun direction at noon is located directly south in the northern hemisphere.

Preferably, in the light control type solar photovoltaic panel described above, the entrance surface of the optical layer for a light control type solar photovoltaic module is inclined at an angle in a range of 0 to 20° with respect to a vertical line. With this configuration, it is not necessary that the panel be installed in a largely inclined state, which allows the installation area to be reduced.

Preferably, in the light control type solar photovoltaic panel described above, the prism axis in an installed state is inclined at an angle in a range of +10 to +50° with respect to a vertical direction. With this configuration, the sunlight can be received along the prism axes and the photovoltaic cell can be efficiently irradiated with the sunlight.

Preferably, in the light control type solar photovoltaic panel described above, a number of prismatic optical elements are formed such that prism axes thereof are inclined toward a predetermined direction at a plurality of angles. A solar photovoltaic module or the like in which the optical layer for at light control type solar photovoltaic module is used has the excellent directionality to the sunlight even if the altitude of the sun changes from season to season.

The angle of the apex formed by lateral surfaces of the square pyramid prism is not particularly limited. However, the apex is preferably formed at an angle of 30 to 135°, more preferably at an angle of 45 to 125°. The angle of the apex can appropriately be changed depending on an intended installation site and an intended installation angle of the solar photovoltaic panel and an intended design for the directionality to the sunlight.

In the cube corner prisms, the apex is usually formed at 90° by the lateral surfaces. Preferably, the apex is formed at an angle of 30 to 135°, more preferably at an angle of 45 to 125°. The apex can appropriately be changed depending on an intended installation site and an intended installation angle of the solar photovoltaic panel and an intended design for the directionality to the sunlight.

The prism axes of the plurality of prismatic optical elements are preferably provided such that at least prismatic optical elements adjacent to each other are symmetrical in relation to the common line. Accordingly, an appearance of the light control type solar photovoltaic panel can be improved, the optical layer can be molded with high accuracy, maintenance of accuracy and inspection of the post-molding optical element can easily be performed, and an amount of light incident to the solar photovoltaic panel can be increased.

In the invention, because the optical layer can be thinned to improve cost and light transmission amount, preferably the base surfaces of the plural prismatic optical elements are formed on the common plane that is aligned with the entrance surface and/or the exit surface of the optical layer.

In the invention, because the optical layer in which the optical yield is improved by matching the areas of opposite surfaces of the optical element, preferably some base surfaces of the plural prismatic optical elements are not formed on the common plane that is aligned with the entrance surface and/or the exit surface of the optical layer.

The air layer provided on the apex side of the optical element can efficiently refract the incident solar beam to irradiate the photovoltaic cell with the solar beam.

In the invention, the prismatic optical elements are preferably formed in both the entrance surface and the exit surface. Accordingly, various optical characteristics can be obtained, and the amount of light incident to the solar photovoltaic panel can be increased.

In the invention, the prismatic optical elements more preferably have the identical shapes, and the phases of the prismatic optical elements are matched with each other between the entrance surface and the exit surface. Therefore, various optical characteristics can be obtained, and the amount of light incident to the solar photovoltaic panel can be increased.

In the invention, the prismatic optical element formed in the entrance surface preferably differs from the prismatic optical element formed in the exit surface. Accordingly, various optical characteristics can be obtained, and the amount of light incident to the solar photovoltaic panel can be increased.

In the invention, at least two types of pairs of symmetrical elements are preferably formed. Accordingly, various optimal characteristics can be obtained, and the amount of light incident to the solar photovoltaic panel can be increased.

Preferably, the resins contain an ultraviolet absorber, an antioxidizing agent, and a light stabilizer in order to provide the weather resistance.

The photovoltaic cell that can be used in the invention is not particularly limited.

Examples of the photovoltaic cell that can preferably be used in the invention include inorganic photovoltaic cells made of Si, GaAs, CuInGaSe, and CdTe and organic photovoltaic cells such as a dye sensitization type photovoltaic cell.

For example, a single junction type cell, a monolithic multi junction type cell, and mechanical stack cell in which various photovoltaic cells having different sensitivity regions are coupled are preferably used as a structure of the photovoltaic cell that can be used in the invention.

In the light control type solar photovoltaic panel in which the optical layer for a light control type solar photovoltaic module is provided according to a preferred embodiment of the invention, the prism axes of the prismatic optical elements are inclined at angles in a range of -40° to +40° relative to the east-west direction when the panel is oriented directly south. Therefore, the change in light amount with the movement of the sun during the day can be reduced, and the improvement of the directionality to the sunlight can be achieved.

Preferably, symmetrical optical elements having optical axes inclined at angles in a range of -40° to -5° and/or +5° to +40° relative to the east-west direction when the panel is oriented directly south are arranged as a pair in order that light-receiving efficiency is improved whether the sunlight comes from the east or the west.

For example, in order to improve the light-receiving efficiency, it is preferable to provide a plurality of pairs of symmetrical optical elements having prism axes inclined at +40°, -40°, +5°, -5°, +40°, -40°, +5°, -5°, ... relative to the east-west direction when the panel is oriented directly south.

Preferably, the use of the element group in which the inclination directions of the prism axes are distributed in the east-west direction improves the directionality to the sunlight.

In any one of the above-described techniques in which the prism axes are inclined, the light-receiving efficiency of the sunlight can be improved by orienting the prism axes toward the sun direction.

### Effect of the Invention

In the conventional solar photovoltaic panel, it is necessary that the panel be installed while incline. Therefore, the relatively large installation area is required to restrict the installation site, and unfortunately the installation area is degraded. On the other hand, in the invention, the problem can be solved by providing the optical layer inclined in the fixed direction, and therefore excellent improvement of the installation area can be obtained.

In the conventional solar photovoltaic panel, the direction or inclination angle of the installed solar photovoltaic panel are not always optimum due to the movement of the sun during the day, the change in culmination altitude from season to season, and the like, which results in the problem that the directionality to the sunlight is degraded. On the other hand, in the invention, the problem can be solved to obtain the excellent directionality to the sunlight.

Additionally, a used amount of the photovoltaic cell having a large proportion of raw material cost in the solar photovoltaic panel can be reduced.

### Brief Description of the Drawings

FIG. 1 is a view illustrating a solar photovoltaic panel according to a conventional technique and a solar beam locus.
FIG. 2 is a view illustrating the solar photovoltaic panel according to the conventional technique and a solar beam locus.
FIG. 3 is a view illustrating the solar photovoltaic panel according to the conventional technique and a solar beam locus.
FIG. 4 is a view illustrating the solar photovoltaic panel according to the conventional technique and a solar beam locus.
FIG. 5 is a view illustrating a solar photovoltaic panel according to an embodiment of the invention and solar beam loci.
FIG. 6 is a view illustrating a solar photovoltaic panel according to an embodiment of the invention and solar beam loci.
FIG. 7 is a perspective view illustrating prismatic optical elements according to a conventional technique.
FIG. 8 is a side view illustrating the prismatic optical elements according to the conventional technique.
FIG. 9 is a plan view illustrating the prismatic optical elements according to the conventional technique.
FIG. 10 is a perspective view illustrating prismatic optical elements according to a conventional technique.
FIG. 11 is a side view illustrating the prismatic optical elements according to the conventional technique.
FIG. 12 is a plan view illustrating the prismatic optical elements according to the conventional technique.
FIG. 13 is a perspective view illustrating an optical layer for a light control type solar photovoltaic module according to a reference example.
FIG. 14 is a side view illustrating the optical layer for a light control type solar photovoltaic module according to the reference example.
FIG. 15 is a plan view illustrating the optical layer for a light control type solar photovoltaic module according to the reference example.
FIG. 16 is a perspective view illustrating an optical layer for a light control type solar photovoltaic module according to a reference example.
FIG. 17 is a side view illustrating the optical layer for a light control type solar photovoltaic module according to the reference example.
F'IG. 18 is a plan view illustrating the optical layer for a light control type solar photovoltaic module according to the reference example.
FIG. 19 is a perspective view illustrating an optical layer for a light control type solar photovoltaic module according to a reference example.
FIG. 20 is a side view illustrating the optical layer for a light control type solar photovoltaic module according to the reference example.
FIG. 21 is a plan view illustrating the optical layer for a light control type solar photovoltaic module according to the reference example.
FIG. 22 is a perspective view illustrating an optical layer for a light control type solar photovoltaic module according to a reference example.
FIG. 23 is a side view illustrating the optical layer for a light control type solar photovoltaic module according to the reference example.
FIG. 24 is a plan view illustrating the optical layer for a light control type solar photovoltaic module according to the reference example.
FIG. 25 is a perspective view illustrating an optical layer for a light control type solar photovoltaic module according to a reference example.
FIG. 26 is a side view illustrating the optical layer for a light control type solar photovoltaic module according to the reference example.
FIG. 27 is a plan view illustrating the optical layer for a light control type solar photovoltaic module according to the reference example.
FIG. 28 is a perspective view illustrating an optical layer for a solar photovoltaic module according to a conventional technique.
FIG. 29 is a side view illustrating the optical layer for a solar photovoltaic module according to the conventional technique.
FIG. 30 is another side view illustrating the optical layer for a solar photovoltaic module according to the conventional technique.
FIG. 31 is a plan view illustrating the optical layer for a solar photovoltaic module according to the conventional technique.
FIG. 32 is a perspective view illustrating an optical layer for a light control type solar photovoltaic module according to a reference example.
FIG. 33 is a side view illustrating the optical layer for a light control type solar photovoltaic module according to the reference example.
FIG. 34 is another side view illustrating the optical layer for a light control type solar photovoltaic module according to the reference example.
FIG. 35 is a plan view illustrating the optical layer for a light control type solar photovoltaic module according to the reference example.
FIG. 36 is a perspective view illustrating an optical layer for a light control type solar photovoltaic module according to a reference example.
FIG. 37 is a side view illustrating the optical layer for a light control type solar photovoltaic module according to the reference example.
FIG. 38 is another side view illustrating the optical layer for a light control type solar photovoltaic module according to the reference example.
FIG. 39 is a plan view illustrating the optical layer for a light control type solar photovoltaic module according to the reference example.
FIG. 40 is a perspective view illustrating an optical layer for a light control type solar photovoltaic module according to an embodiment of the invention.
FIG. 41 is a side view illustrating the optical layer for a light control type solar photovoltaic module according to the embodiment of the invention.
FIG. 42 is a side view illustrating the optical layer for a light control type solar photovoltaic module according to the embodiment of the invention.
FIG. 43 is a plan view illustrating the optical layer for a light control type solar photovoltaic module according to the embodiment of the invention.
FIG. 44 is a perspective view illustrating an optical GNC09021EP-B04EP layer for a light control type solar photovoltaic module according to an embodiment of the invention.
FIG. 45 is a side view illustrating the optical layer for a light control type solar photovoltaic module according to the embodiment of the invention.
FIG. 46 is a plan view illustrating the optical layer for a light control type solar photovoltaic module according to the embodiment of the invention.
FIG. 47 is a sectional view of a solar photovoltaic module according to an embodiment of the invention.
F1G. 48 is a perspective view illustrating an optical layer for a light control type solar photovoltaic module according to an embodiment of the invention.
FIG. 49 is a side view illustrating the optical layer for a light control type solar photovoltaic module according to the embodiment of the invention.
Fig. 50 is another side view illustrating the optical layer for a light control type solar photovoltaic module according to the embodiment of the invention.
FIG. 51 is a plan view illustrating the optical layer for a light control type solar photovoltaic module according to the embodiment of the invention.
FIG. 52 is a view illustrating another example of prismatic optical elements used in an optical layer for a light control type solar photovoltaic module according to an embodiment of the invention.
FIG. 53 is a view illustrating a state in which light is transmitted through the optical layer according to the conventional technique illustrated in FIGS. 7 to 9 and FIGS. 28 to 31.
FIG. 54 is a view illustrating a state in which light is transmitted through the optical layer according to the conventional technique illustrated in FIGS. 10 to 12.
FIG. 55 is a view illustrating a state in which light is transmitted through the optical layer for a light control type solar photovoltaic module according to the reference example illustrated in FIGS. 13 to 15.
FIG. 56 is a view illustrating a state in which light is transmitted through the optical layer for a light control type solar photovoltaic module according to the reference example illustrated in FIGS. 16 to 18.
FIG. 57 is a view illustrating a state in which light is transmitted through the optical layer for a light control type solar photovoltaic module according to the reference example illustrated in FIGS. 19 to 21.
FIG. 58 is a view illustrating a state in which light is transmitted through the optical layer for a light control type solar photovoltaic module according to the reference example illustrated in FIGS. 22 to 24.
FIG. 59 is a view illustrating a state in which light is transmitted through the optical layer for a light control type solar photovoltaic module according to the reference example illustrated in FIGS. 25 to 27.
FIG. 60 is a view illustrating a state in which light is transmitted through the optical layer for a light control type solar photovoltaic module according to the reference example illustrated in FIGS. 32 to 35.
FIG. 61 is a view illustrating a state in which light is transmitted through the optical layer for a light control type solar photovoltaic module according to the reference example illustrated in FIGS. 36 to 39.
FIG. 62 is a view illustrating a state in which light is transmitted through the optical layer for a light control type solar photovoltaic module according to the embodiment of the invention illustrated in FIGS. 40 to 43.
FIG. 63 is a view illustrating a state in which light is transmitted through the optical layer for a light control type solar photovoltaic module according to another embodiment of the invention illustrated in FIGS. 44 to 46.

### Best Mode for Carrying Out the Invention

Preferred embodiments of a light control type solar photovoltaic panel according to the invention will be described below with reference to the drawings.

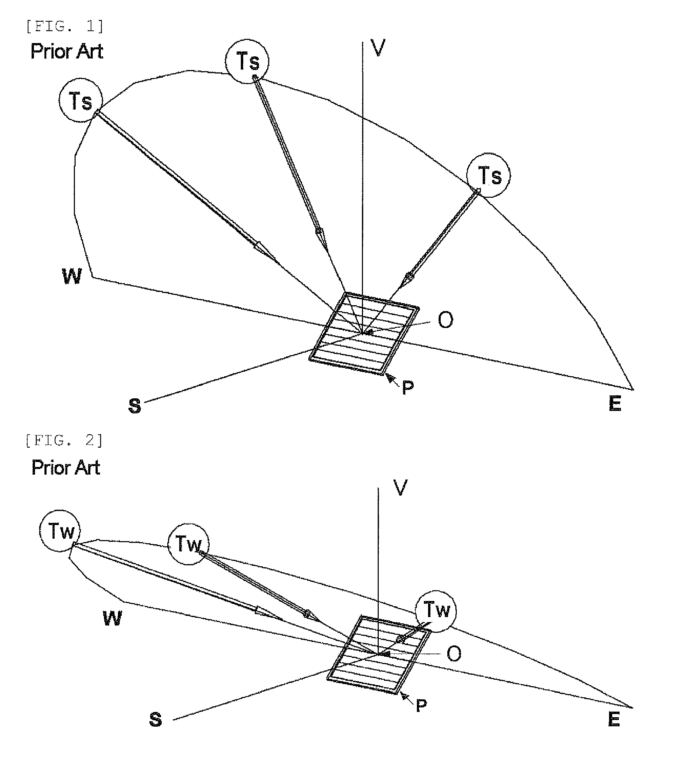

FIG. 1 is a perspective view illustrating a solar photovoltaic panel P having an inclined panel surface according to a conventional technique and a solar beam locus during the day. In particular, a culmination altitude of the sun Ts is illustrated to be high in FIG. 1, and thus FIG. 1 is a perspective view illustrating a movement locus of the sun Ts during summertime.

As illustrated in FIG. 1, the solar photovoltaic panel is installed in a state where the panel surface P is oriented toward the south (S) and the solar photovoltaic panel is inclined with respect to a vertical direction V from a center O of the panel. The directionality to the sunlight is improved by inclining the panel surface P. However, an entrance angle between the panel surface P and the solar beam keeps changing as the sun T rises from the east (E), passes through the culmination position and sets in the west (W), and accordingly, the power generation efficiency keeps changing and becomes maximum at the culmination position.

The solar photovoltaic panel P having the inclined panel surface according to the conventional technique is disadvantageous in that the power generation efficiency is significantly degraded at an excessive entrance angle because the solar beam is reflected by the panel surface and does not reach a photovoltaic cell in the panel.

This problem becomes particularly serious when a prismatic optical layer is not used.

FIG. 2 is a perspective view also illustrating the solar photovoltaic panel P having the inclined panel surface according to the conventional technique and a solar beam locus during the day. In particular, a culmination altitude of the sun Tw is illustrated to be low in FIG. 2, and thus FIG. 2 is a perspective view illustrating a movement locus of the sun during wintertime.

In FIG. 2, similarly to FIG. 1, an entrance angle between the panel surface P and the solar beam keeps changing as the sun Tw rises from the east (E) passes through the culmination position and sets in the west (W), and accordingly, the power generation efficiency keeps changing and becomes maximum at the culmination position.

In the wintertime, the entrance angle increases because the culmination altitude is low. Thus, an excessive entrance angle more likely to occur compared with the summertime and the solar beam is reflected by the panel surface and hardly reaches the photovoltaic cell in the panel. Therefore, there is a problem that the power generation efficiency is significantly degraded in the solar photovoltaic panel P having the inclined panel surface according to the conventional technique.

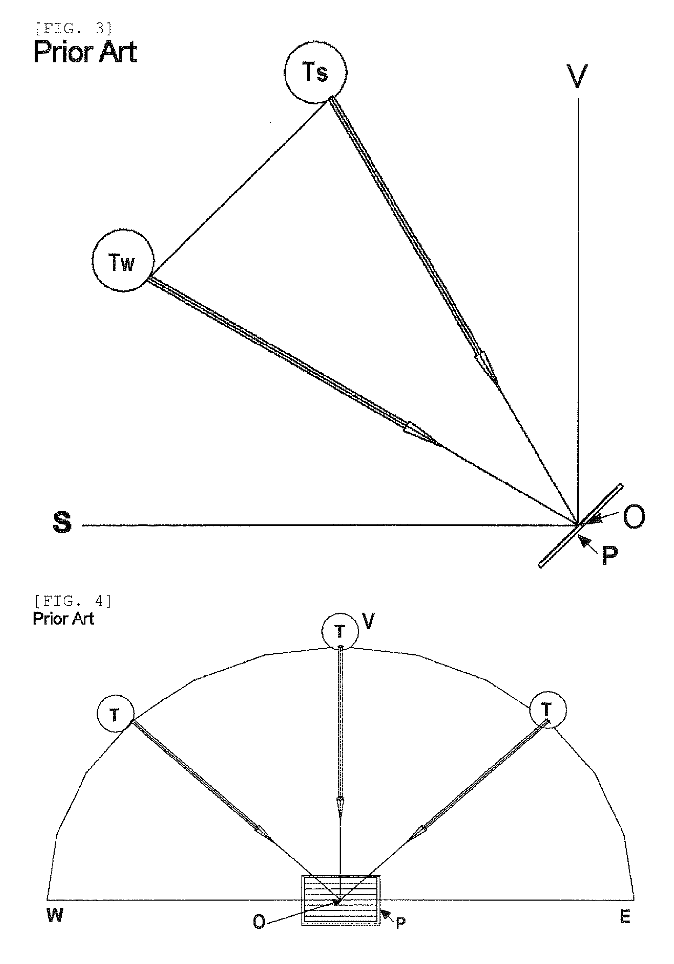

FIG. 3 is a side view illustrating the solar photovoltaic panel P having the inclined panel surface according to the conventional technique and a relationship between the culmination altitudes of the wintertime sun Tw and the summertime sun Ts and the panel entrance angle. As illustrated in FIG. 3, the culmination altitude of the wintertime sun T is low while the culmination altitude of the summertime sun T is high.

In order to equalize the power generation efficiency in the wintertime and the summertime, an average of the solar angles of the culmination positions in the wintertime and the summertime can be used as an inclination angle of the panel. However, the use of this inclination angle of the panel sacrifices conversion efficiency in both the wintertime and the summertime.

FIG. 4 is a side view illustrating the solar photovoltaic panel P having the inclined panel surface according to the conventional technique and a solar beam locus during the day.

As illustrated in FIG. 4, the entrance angle between the panel surface P and the solar beam keeps changing as the sun T rises from the east (E) at dawn, passes through the culmination position and sets in the west (W). Accordingly, the power generation efficiency keeps changing and becomes maximum at the culmination position.

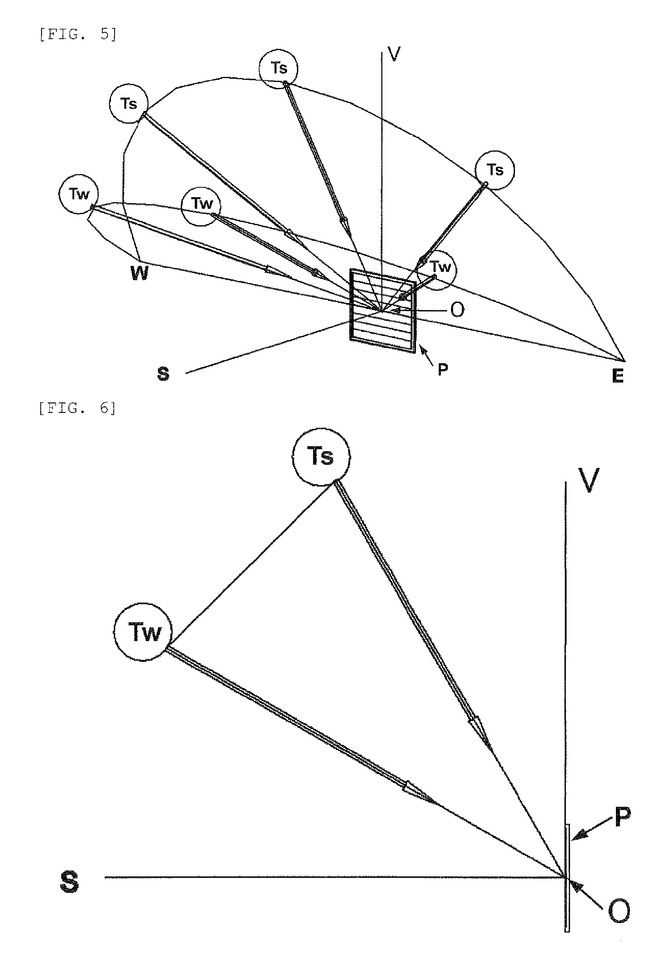

FIG. 5 is a perspective view illustrating a solar photovoltaic panel P having a panel surface that is installed substantially vertically according to an embodiment of the invention, positions of the summertime sun Ts and the wintertime sun Tw daily and during the day, and solar beam loci during the day. Because the solar photovoltaic panel according to the embodiment of the invention is vertically installed, the solar photovoltaic panel has an advantage that an installation area is smaller than that of the conventional inclined solar photovoltaic panel.

Although an installation site of the conventional solar photovoltaic panel P is limited to a flat ground, a roof surface and the like, the solar photovoltaic panel according to the embodiment of the invention can be installed even on a vertical surface such as a wall surface, a fence and a sign and an installable range therefor can be widened.

FIG. 6 is a side view illustrating the solar photovoltaic panel P having the panel surface that is installed substantially vertically according to the embodiment of the invention and the relationship between the culmination altitudes of the wintertime sun T and the summertime sun T and the panel entrance angle.

As illustrated in FIG. 6, in the solar photovoltaic panel P having the panel surface that is installed substantially vertically according to the embodiment of the invention, the entrance angle with respect to the panel surface increases in both the wintertime and the summertime, and the entrance angle cannot be equalize in the wintertime and the summertime by using the inclination angle of the panel.

The disadvantage of the entrance angle in the embodiment of the invention as described above can be improved by inclining optical axes of optical elements arranged in an optical layer in a front surface of the solar photovoltaic module toward the entrance axis of the sun Ts or Tw.

Similarly to the conventionally known inclined solar photovoltaic panel P, it is preferable that the average of the solar angles of culmination positions in the wintertime and the summertime be employed as an inclination angle of a prism axis in order to equalize the power generation efficiency in the wintertime and summertime.

In the embodiment of the invention, a prism axis is defined as a center axis that is at an equal distance from lateral surfaces forming an element.

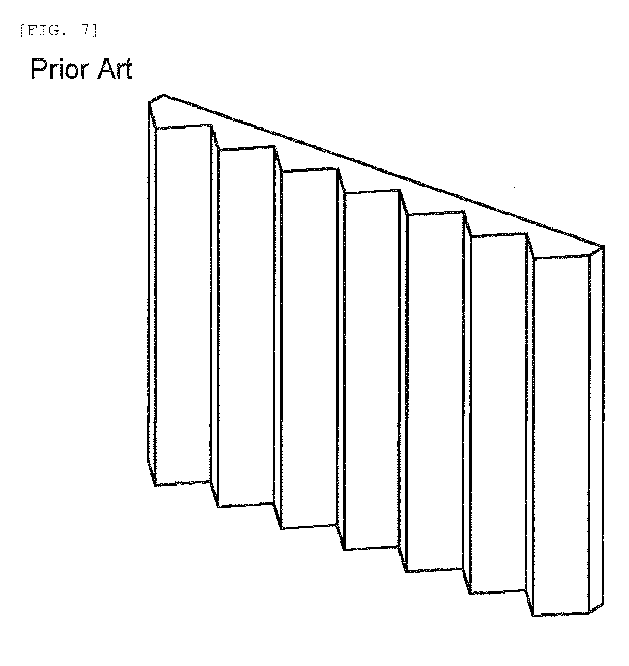

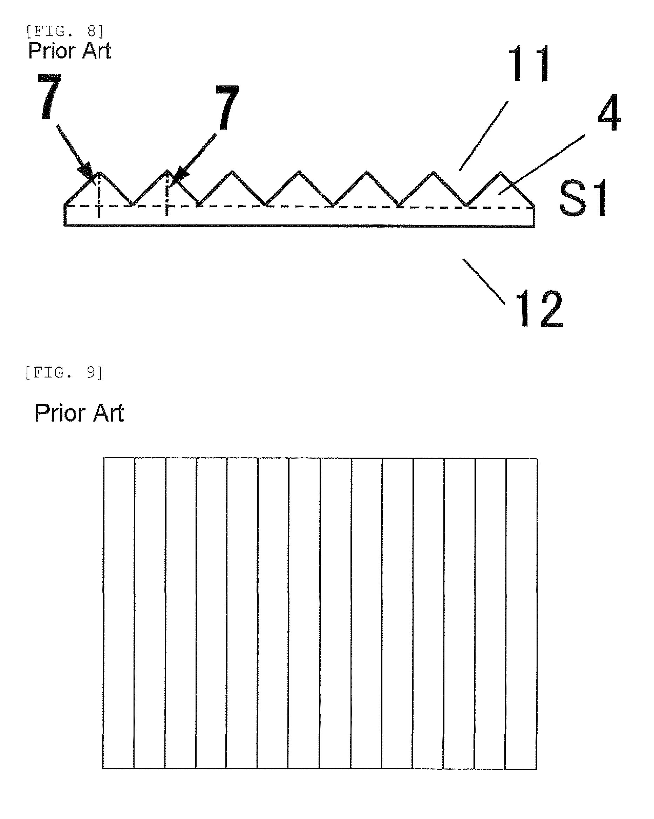

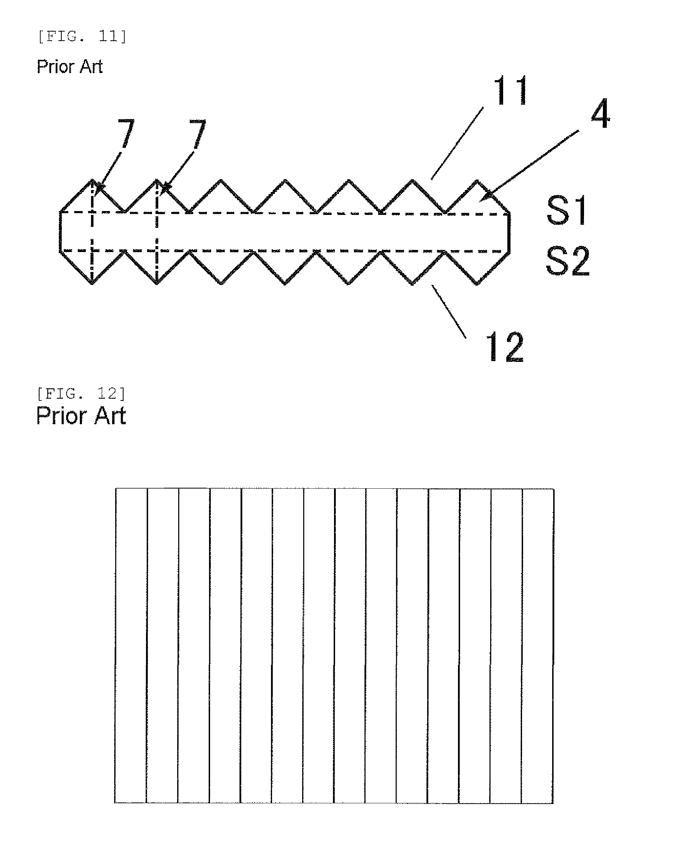

FIGS. 7, 8, and 9 illustrate an optical layer according to a conventional technique. Specifically, FIG. 7 is a perspective view illustrating the optical layer of the conventional technique, FIG. 8 is a side view illustrating the optical layer of the conventional technique, and FIG. 12 is a plan view illustrating the optical layer of the conventional technique. As illustrated in FIGS. 7 to 9, a number of prismatic optical elements made of linear prisms are formed in an entrance surface 11 of the optical layer. The prismatic optical elements are on a common plane S1 defined by a common base shared by a plurality of adjacent prismatic optical elements provided in the entrance surface 11, and a prism axis 7 of a prismatic optical element corresponds to a perpendicular line drawn from an apex of the optical element to the common plane.

In the linear prism illustrated in FIG. 7, a straight line is formed by a set of apexes of the optical elements.

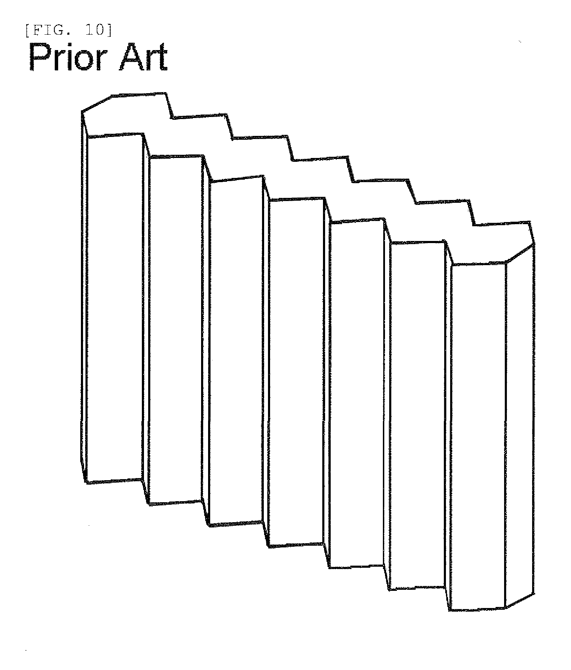

FIGS. 10, 11, and 12 illustrate an optical layer according to a conventional technique. Specifically, FIG. 10 is a perspective view illustrating prismatic optical elements according to the conventional technique, FIG. 11 is a side view illustrating the prismatic optical elements according to the conventional technique, and FIG. 12 is a plan view illustrating the prismatic optical elements according to the conventional technique. As illustrated in FIGS. 10 to 12, in an optical layer for a light control type solar photovoltaic module according to this reference example, a number of prismatic optical elements are formed in both an entrance surface 11 and an exit surface 12. The prismatic optical elements are made of linear prisms. The prismatic optical elements are on common planes S1 and S2, defined by common bases shared by a plurality of adjacent prismatic optical elements provided in the entrance surface 11 and the exit surface 12, respectively, and a prism axis 7 of each prismatic optical element corresponds to a perpendicular line drawn to the common planes.

When a plurality of prismatic optical elements are arranged in both the entrance surface 11 and the exit surface 12 as described above, it is preferable that phases of the prismatic optical elements in the entrance surface 11 and the exit surface 12 be matched with each other as in FIGS. 9 to 11 in order to maximize light entrance efficiency.

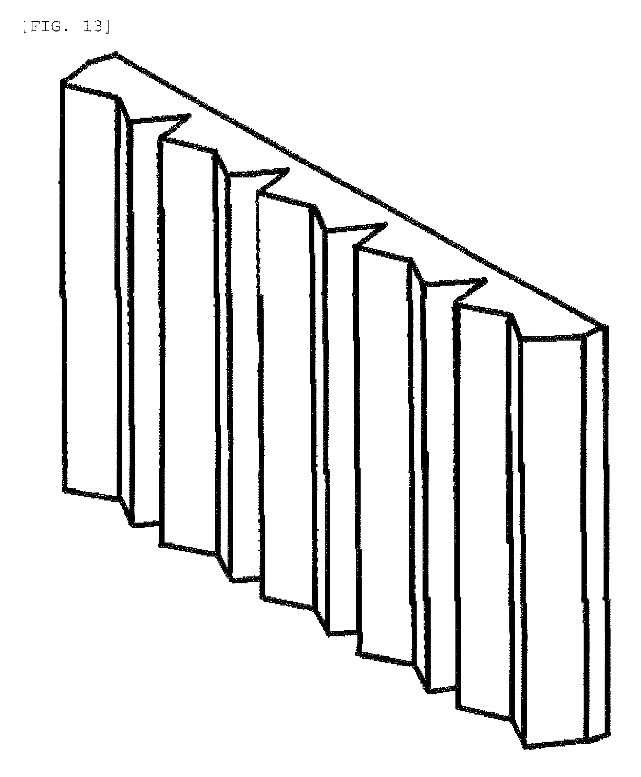

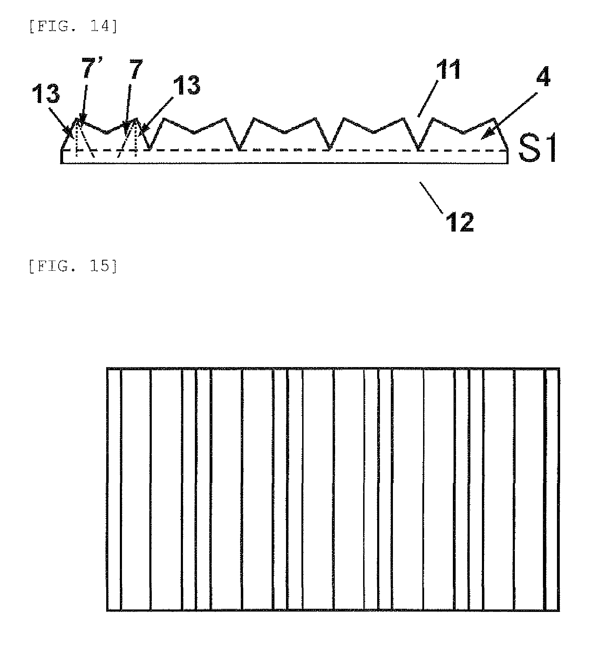

FIGS. 13, 14, and 15 illustrate an optical layer for a light control type solar photovoltaic module according to another reference example. Specifically, FIG. 13 is a perspective view illustrating the optical layer for a light control type solar photovoltaic module according to this reference example, FIG. 14 is a side view illustrating the optical layer for a light control type solar photovoltaic module according to this reference example, and FIG. 15 is a plan view illustrating the optical layer for a light control type solar photovoltaic module according to this reference example. As illustrated in FIGS. 13 to 15, in the optical layer for a light control type solar photovoltaic module according to this reference example, a number of prismatic optical elements are formed only in an entrance surface 11 while an exit surface 12 thereof is formed flat. The prismatic optical elements are on a common plane S1, defined by a common base shared by adjacent prismatic optical elements provided in the entrance surface 11. Prism axes 7 of some of the prismatic optical elements are inclined toward one direction with respect to a plane 13 perpendicular to the common plane S1 while prism axes 7 of at least some of the other prismatic optical elements are inclined toward the other direction. In this reference example, prism axes 7 and 7' of a pair of prismatic optical elements adjacent to each other are inclined in directions different from each other.

It is preferable to employ the group of prismatic optical elements having different inclination directions of the prism axes as in the optical layer for a light control type solar photovoltaic module illustrated in FIGS. 13 to 15 as described above for improving the directionality to the sunlight. Specifically, the directions in which the inclination directions of the prism axes are distributed are oriented toward the east and the west, which allows the light to be collected for a long time as the sun moves.

In particular, it is preferable that a pair of symmetrical optical elements, inclined at angles in a range of -40° to -5° and/or +5° to +40° relative to the east-west direction when the light control type solar photovoltaic panel on which the prism axes of the prismatic optical elements are mounted is oriented directly south, is arranged so that light-receiving efficiency is improved whether the sunlight comes from the east or the west.

In FIG. 14, heights of recesses of the linear prisms with respect to the common plane S1 are at two different levels. Such a group of prismatic optical elements in which the heights of the recesses are not equal to each other has an advantage that an optical layer for a light control type solar photovoltaic module having an improved optical yield can be obtained by bringing opposite surface areas of the prismatic optical elements close to each other.

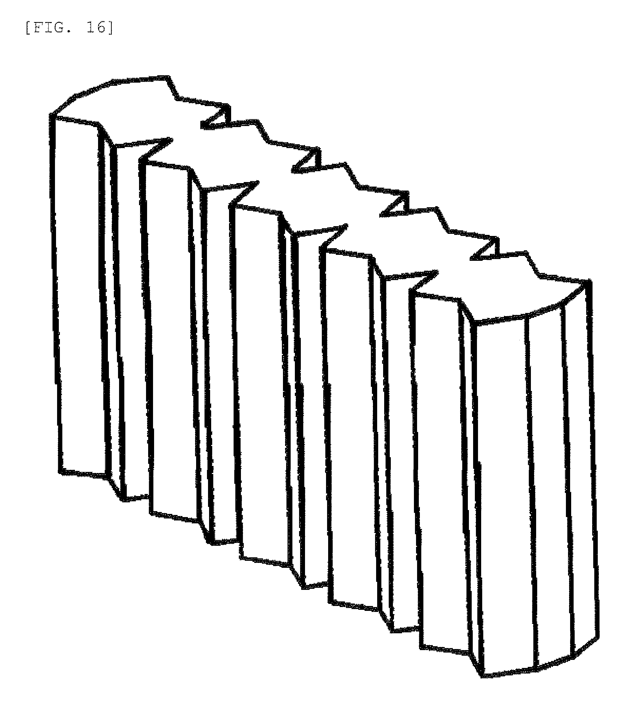

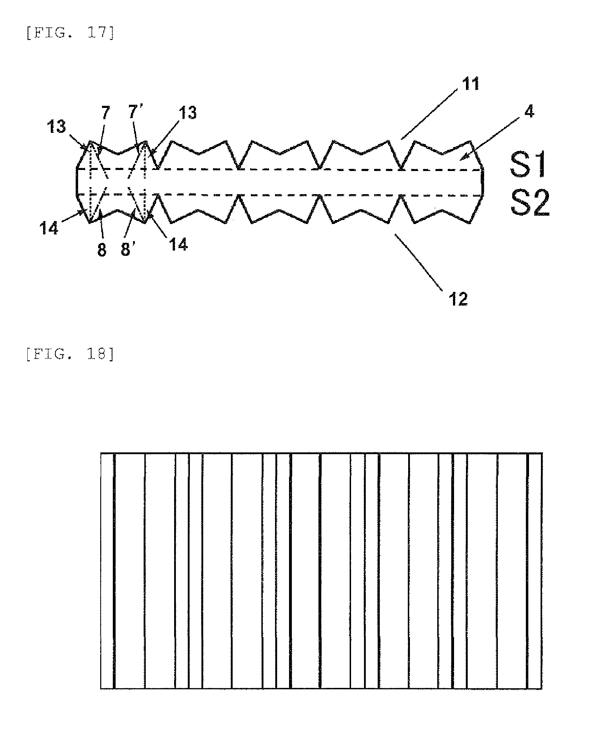

FIGS. 16, 17, and 18 illustrate an optical layer for a light control type solar photovoltaic module according to another reference example. Specifically, FIG. 16 is a perspective view illustrating the optical layer for a light control type solar photovoltaic module according to this reference example, FIG. 17 is a side view illustrating the optical layer for a light control type solar photovoltaic module according to this reference example, and PIG. 18 is a plan view illustrating the optical layer for a light control type solar photovoltaic module according to this reference example. As illustrated in FIGS. 16 to 18, in the optical layer for a light control type solar photovoltaic module according to this reference example, a number of prismatic optical elements made of linear prisms are formed in both an entrance surface 11 and an exit surface 12. In this reference example, the shapes of a number of prismatic optical elements formed in the entrance surface 11 of the optical layer for a light control type solar photovoltaic module are identical to those of a number of prismatic optical elements formed in the exit surface 12 thereof. The prismatic optical elements provided in the entrance surface 11 and the exit surface 12 are on common planes S1 and S2, respectively, defined by common bases shared by the prismatic optical elements adjacent to each other. Prism axes 7 of some of the prismatic optical elements formed in the entrance surface 11 are inclined toward one direction with respect to a plane 13 perpendicular to the common plane S1 while prism axes 7' of at least some of the other prismatic optical elements are inclined toward the other direction. Similarly, prism axes 8 of some of the prismatic optical elements formed in the exit surface 12 are inclined toward one direction with respect to a plane 14 perpendicular to the common plane S2 while prism axes 8' of at least some of the other prismatic optical elements are inclined toward the other direction. In this reference example, prism axes 7 and 7' of a pair of adjacent prismatic optical elements formed in the entrance surface 11 are inclined in directions different from each other, and prism axes 8 and 8' of a pair of adjacent prismatic optical elements formed in the exit surface 12 are inclined in directions different from each other.

Moreover, in this reference example, phases of a number of prismatic optical elements formed in the entrance surface 11 of the optical layer for a light control type solar photovoltaic module are matched with those of a number of prismatic optical elements formed in the exit surface 12 thereof. In other words, a number of prismatic optical elements formed in the entrance surface 11 and a number of prismatic optical elements formed in the exit surface 12 of the optical layer for a light control type solar photovoltaic module are symmetrical in relation to the entrance surface 11 and the exit surface 12.

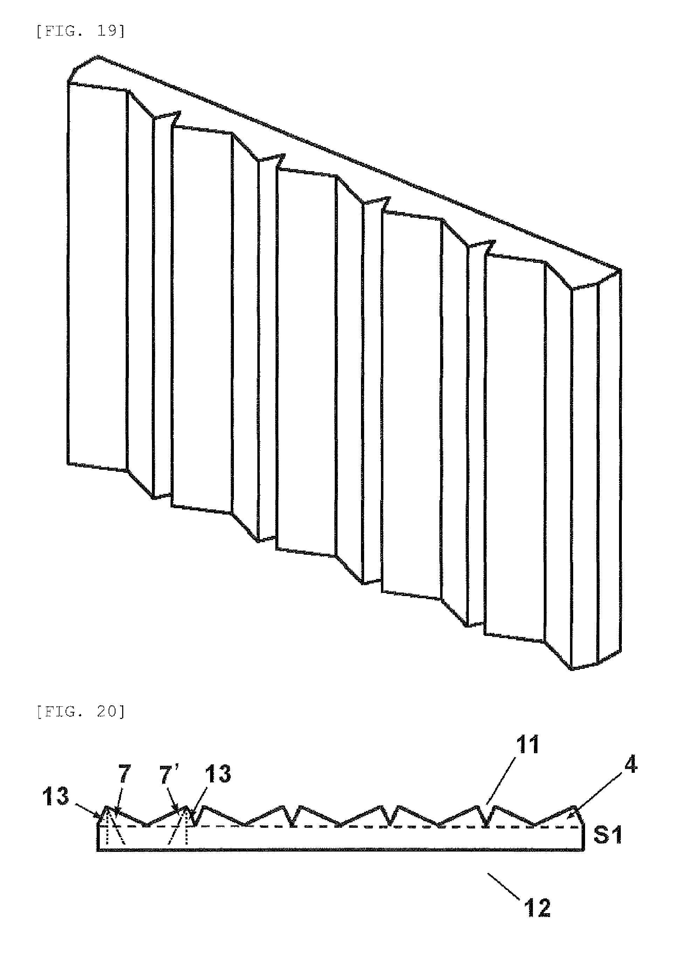

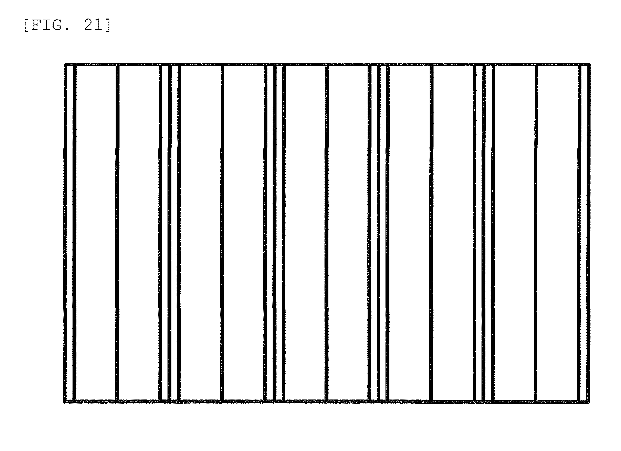

FIGS. 19, 20, and 21 illustrate an optical layer for a light control type solar photovoltaic module according to another reference example. Specifically, FIG. 19 is a perspective view illustrating the optical layer for a light control type solar photovoltaic module according to this reference example, FIG. 20 is a side view illustrating the optical layer for a light control type solar photovoltaic module according to this reference example, and FIG. 21 is a plan view illustrating the optical layer for a light control type solar photovoltaic module according to this reference example. As illustrated in FIGS. 19 to 21, in the optical layer for a light control type solar photovoltaic module according to this reference example, a number of prismatic optical elements made of linear prisms are formed only in an entrance surface 11 while an exit surface 12 is formed flat. The prismatic optical elements formed in the entrance surface 11 are on a common plane S1 defined by a common base shared by the prismatic optical elements adjacent to each other. Prism axes 7 of some of the prismatic optical elements are inclined toward one direction with respect to a plane 13 perpendicular to the common plane S1 while prism axes 7' of at least some of the other prismatic optical elements are inclined toward the other direction. In this reference example, prism axes 7 and 7' of a pair of prismatic optical elements adjacent to each other are inclined in directions different from each other.

In FIG. 20, heights of recesses of the linear prisms with respect to the common plane S1 are equal to each other. Such a group of prismatic optical elements in which the heights of recesses are equal to each other has an advantage that an optical layer for a light control type solar photovoltaic module can be thinned, whereby cost and a light transmission amount are improved, for example.

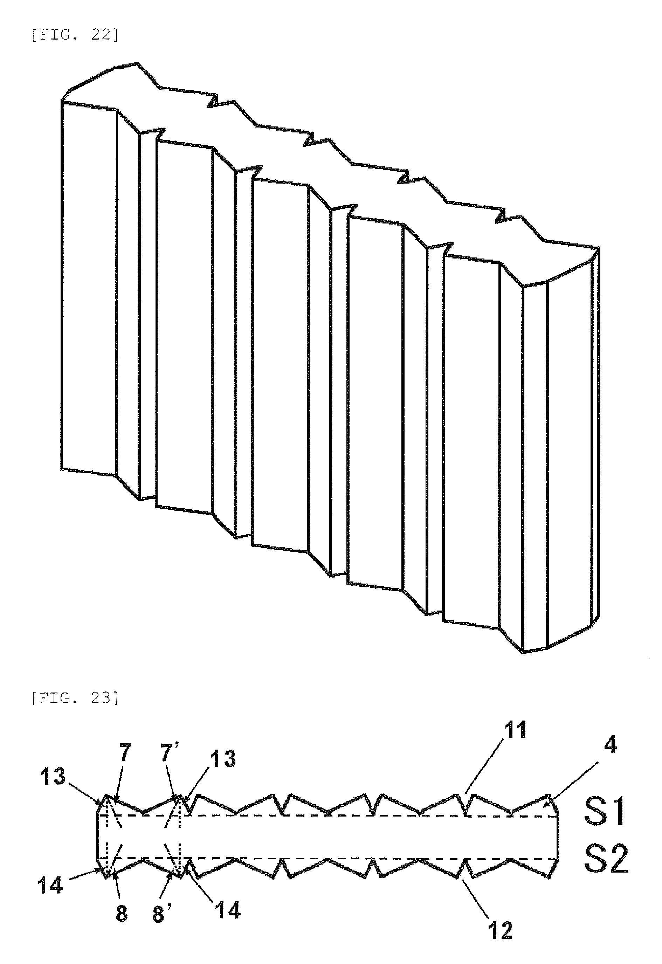

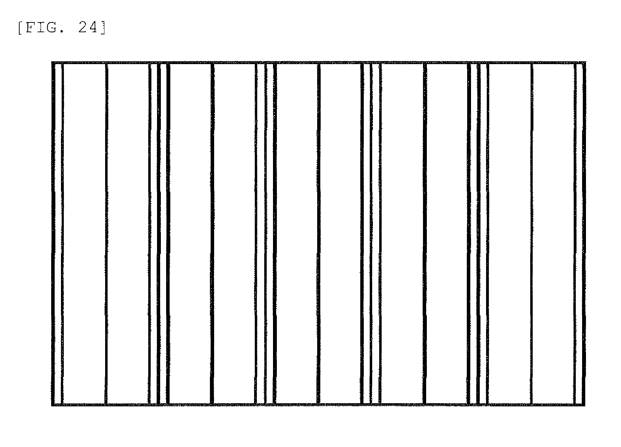

FIGS. 22, 23, and 24 illustrate an optical layer for a light control type solar photovoltaic module according to another reference example. Specifically, FIG. 22 is a perspective view illustrating the optical layer for a light control type solar photovoltaic module according to this reference example, FIG. 23 is a side view illustrating the optical layer for a light control type solar photovoltaic module according to this reference example, and FIG. 24 is a plan view illustrating the optical layer for a light control type solar photovoltaic module according to this reference example. As illustrated in FIGS. 22 to 24, in the optical layer for a light control type solar photovoltaic module according to this reference example, a number of prismatic optical elements made of linear prisms are formed in both an entrance surface 11 and an exit surface 12. In this reference example, the shapes of a number of prismatic optical elements formed in the entrance surface 11 of the optical layer for a light control type solar photovoltaic module are identical to those of a number of prismatic optical elements formed in the exit surface 12. The prismatic optical elements provided in the entrance surface 11 and the exit surface 12 are on common planes S1 and S2, defined by common bases shared by the prismatic optical elements adjacent to each other, respectively. Purism axes 7 of some of the prismatic optical elements formed in the entrance surface 11 are inclined toward one direction with respect to a plane 13 perpendicular to the common plane S1 while prism axes 7' of at least some of the other prismatic optical elements are inclined toward the other direction. Similarly, prism axes 8 of some of the prismatic optical elements formed in the exit surface 12 are inclined toward one direction with respect to a plane 14 perpendicular to the common plane S2 while prism axes 8' of at least some of the other prismatic optical elements are inclined toward the other direction. In this reference example, prism axes 7 and 7' of a pair of adjacent prismatic optical elements formed in the entrance surface 11 are inclined in directions different from each other, and prism axes 8 and 8' of a pair of adjacent prismatic optical elements formed in the exit surface 12 are inclined in directions different from each other.

Moreover, in this reference example, phases of a number of prismatic optical elements formed in the entrance surface 11 of the optical layer for a light control type solar photovoltaic module are matched with those of a number of prismatic optical elements formed in the exit surface 12 thereof. In this reference example, because the shapes of a number of prismatic optical elements formed in the entrance surface 11 are identical to those of a number of prismatic optical elements formed in the exit surface 12, the prismatic optical elements formed in the entrance surface 11 and the prismatic optical elements formed in the exit surface 12 of the optical layer for a light control type solar photovoltaic module are symmetrical in relation to the entrance surface 11 and the exit surface 12.

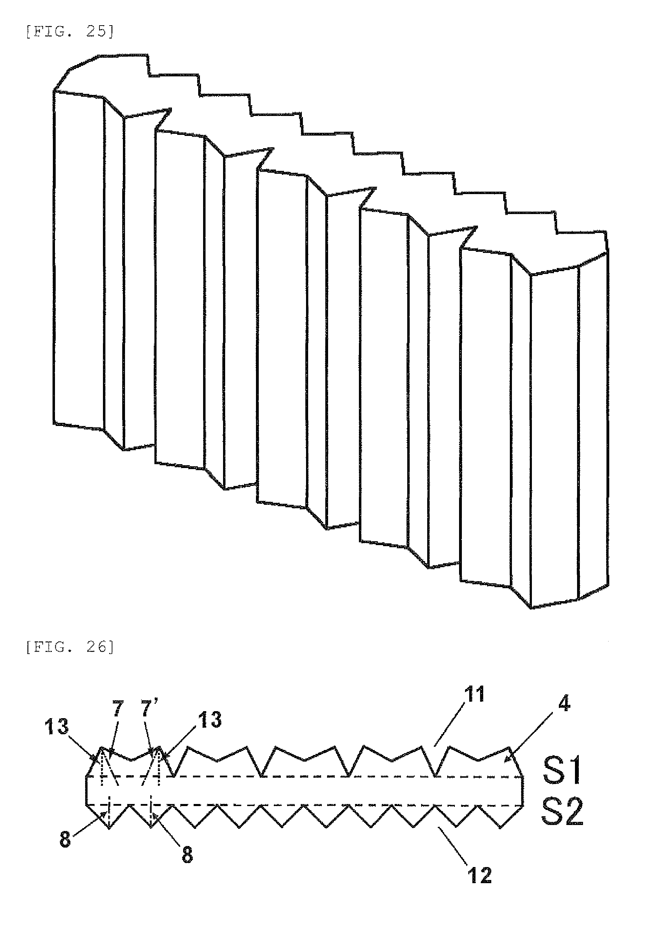

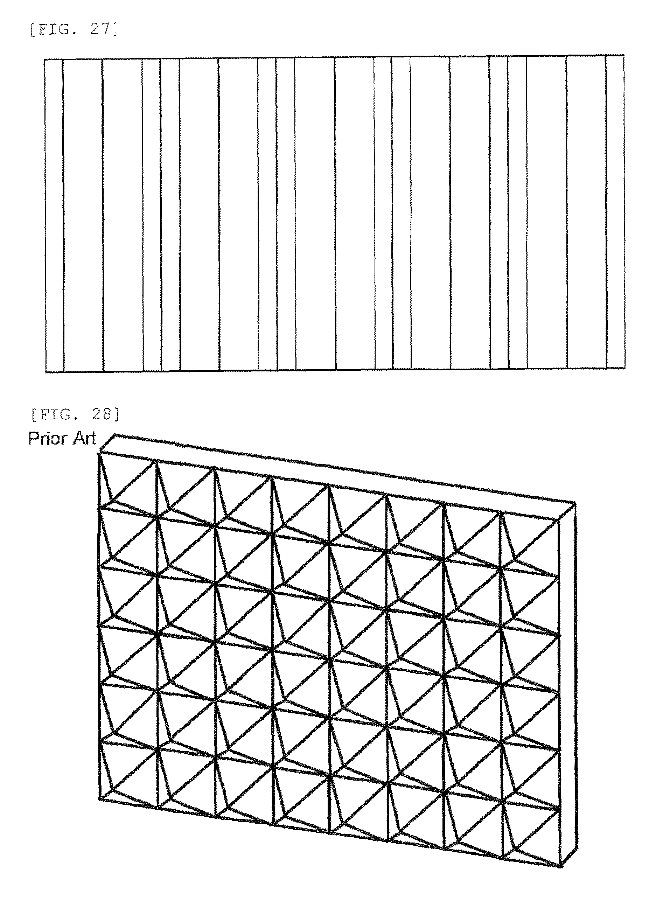

FIGS. 25, 26, and 27 illustrate an optical layer for a light control type solar photovoltaic module according to another reference example. Specifically, FIG. 25 is a perspective view illustrating the optical layer for a light control type solar photovoltaic module according to this reference example, FIG. 26 is a side view illustrating the optical layer for a light control type solar photovoltaic module according to this reference example, and FIG. 27 is a plan view illustrating the optical layer for a light control type solar photovoltaic module according to this reference example. As illustrated in FIGS. 25 to 27, in the optical layer for a light control type solar photovoltaic module according to this reference example, a number of prismatic optical elements made of linear prisms are formed in both an entrance surface 11 and an exit surface 12. In this reference example, the shapes of a number of prismatic optical elements formed in the entrance surface 11 of the optical layer for a light control type solar photovoltaic module are different from those of a number of prismatic optical elements formed in the exit surface 12 thereof. The prismatic optical elements provided in the entrance surface 11 and the exit surface 12 are on common planes S1 and S2, defined by common bases shared by the prismatic optical elements adjacent to each other, respectively. Prism axes 7 of some of the prismatic optical elements formed in the entrance surface 11 are inclined toward one direction with respect to a plane 13 perpendicular to the common plane S1 while prism axes 7' of at least some of the other prismatic optical elements are inclined toward the other direction. In this reference example, prism axes 7 and 7' of a pair of prismatic optical elements adjacent to each other are inclined in directions different from each other. On the other hand, a prism axis 8 of each prismatic optical element formed in the exit surface 12 corresponds to a perpendicular line 14 drawn from an apex of the optical element to the common plane S2.

Moreover, in this reference example, although the shapes of a number of prismatic optical elements formed in the entrance surface 11 of the optical layer for a light control type solar photovoltaic module are different from those of a number of prismatic optical elements formed in the exit surface 12 thereof, phases of a number of prismatic optical elements formed in the entrance surface 11 are matched with those of a number of prismatic optical elements formed in the exit surface 12.

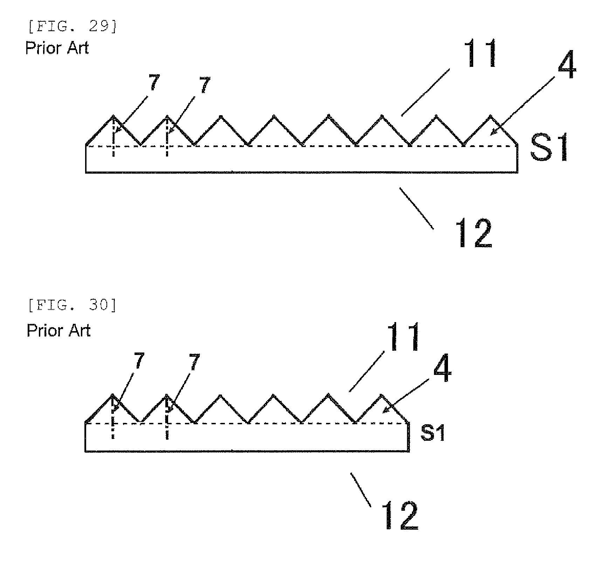

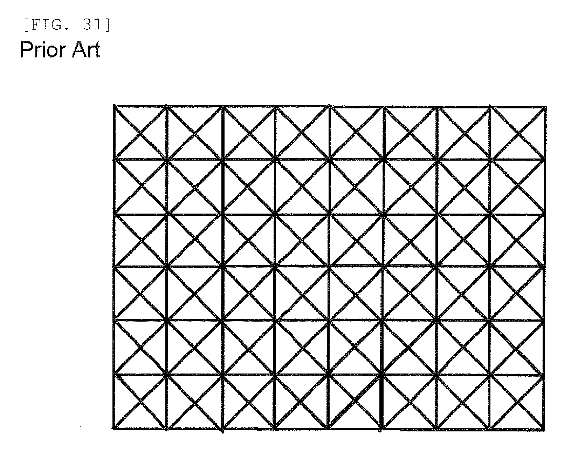

FIGS. 28, 29, 30, and 31 illustrate an optical layer according to a conventional technique. Specifically, FIG. 28 is a perspective view illustrating the optical layer for a solar photovoltaic module according to the conventional technique, FIG. 29 is a side view illustrating the optical layer for a solar photovoltaic module according to the conventional technique, FIG. 30 is another side view illustrating the optical layer for a solar photovoltaic module according to the conventional technique, and FIG. 31 is a plan view illustrating the optical layer for a solar photovoltaic module according to the conventional technique. As illustrated in FIGS. 28 to 31, a number of prismatic optical elements made of square pyramid prisms are formed in an entrance surface 11 of the optical layer while an exit surface 12 thereof is formed flat. The prismatic optical elements provided in the entrance surface 11 are on a common plane S1, defined by a common base shared by the prismatic optical elements adjacent to each other. A prism axis of each of the prismatic optical elements formed in the entrance surface 11 corresponds to a perpendicular line drawn from an apex of the prismatic optical element to the common plane S1

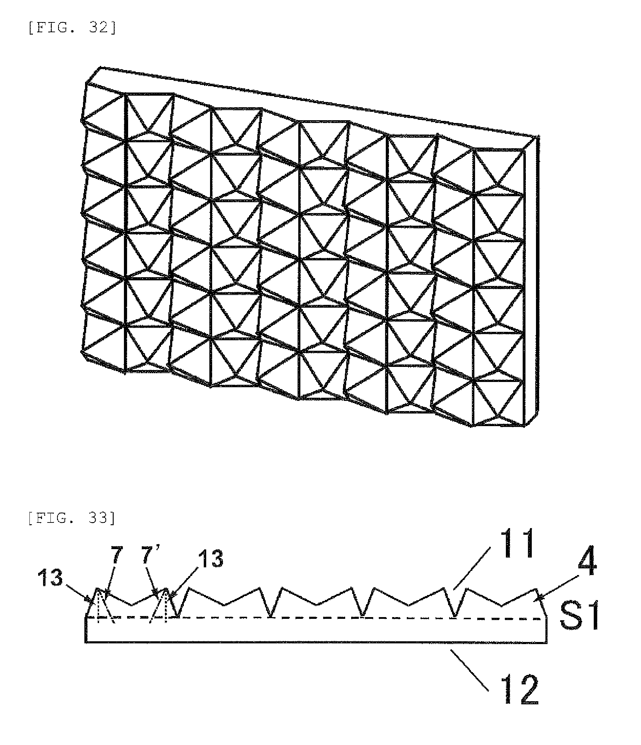

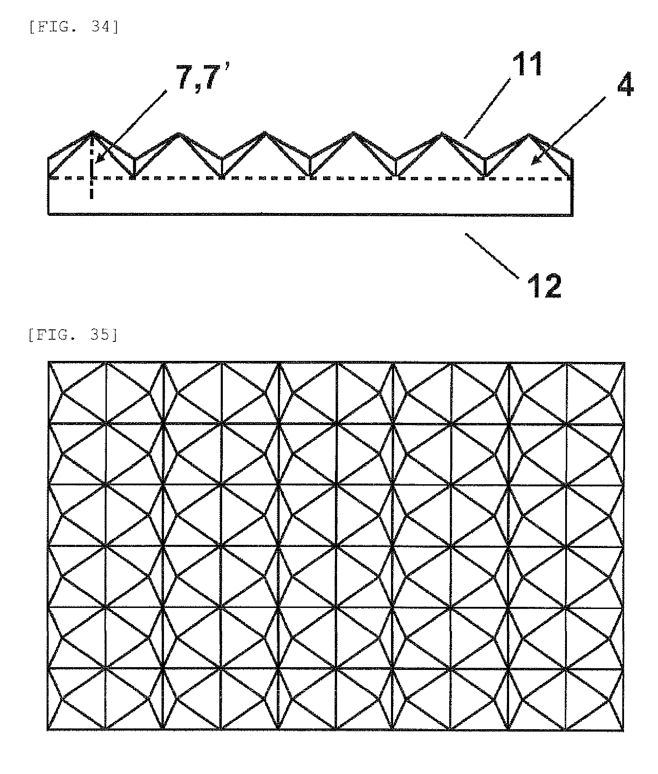

FIGS. 32, 33, 34, and 35 illustrate an optical layer for a light control type solar photovoltaic module according to another reference example. Specifically, FIG. 32 is a perspective view illustrating the optical layer for a light control type solar photovoltaic module according to this reference example, FIG. 33 is a side view illustrating the optical layer for a light control type solar photovoltaic module according to this reference example, FIG. 34 is another side view illustrating the optical layer for a light control type solar photovoltaic module according to this reference example, and FIG. 35 is a plan view illustrating the optical layer for a light control type solar photovoltaic module according to this reference example. As illustrated in FIGS. 32 to 35, a number of prismatic optical elements made of square pyramid prisms are formed in an entrance surface 11 of the optical layer for a light control type solar photovoltaic module according to this reference example while an exit surface 12 thereof is formed flat. The prismatic optical elements provided in the entrance surface 11 are on a common plane S1 defined by a common base shared by the prismatic optical elements adjacent to each other. Prism axes 7 of some of the prismatic optical elements formed in the entrance surface 11 are inclined toward one direction with respect to a plane 13 perpendicular to the common plane S1 while prism axes 7' of at least some of the other prismatic optical elements are inclined toward the other direction. Because the side view of Fig. 34 differs from that of FIG. 33, the prism axes 7 and 7' appear to overlap with each other in FIG. 34. In this reference example, prism axes 7 and 7' of a pair of prismatic optical elements adjacent to each other are inclined in directions different from each other.

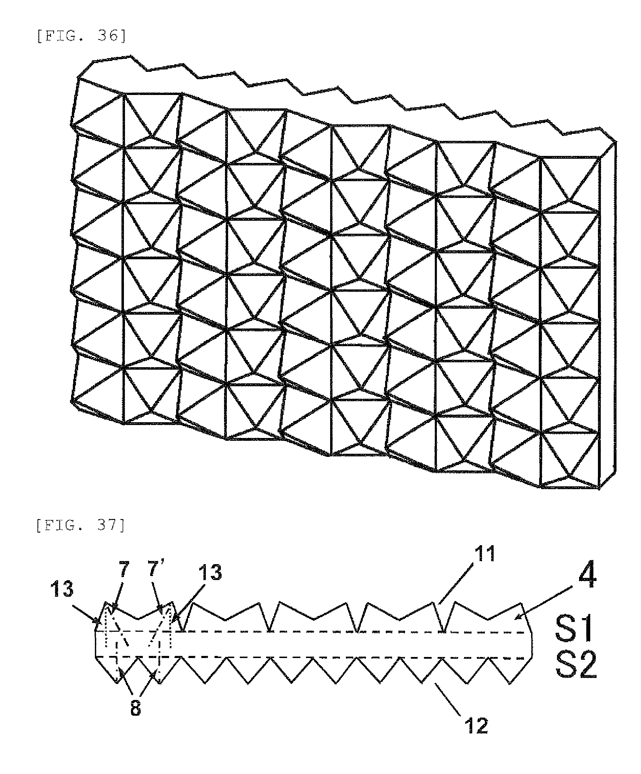

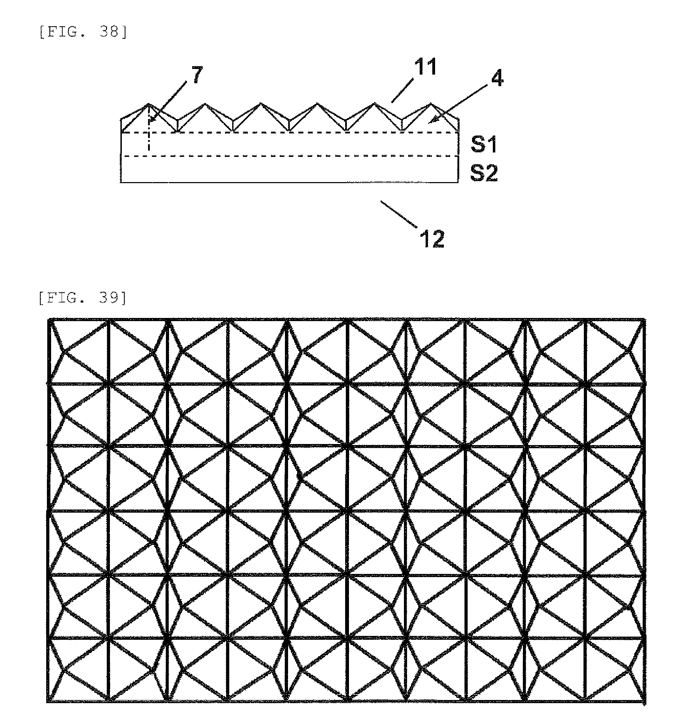

FIGS. 36, 37, 38, and 39 illustrate an optical layer for a light control type solar photovoltaic module according to another reference example. Specifically, FIG. 36 is a perspective view illustrating the optical layer for a light control type solar photovoltaic module according to this reference example, FIG. 37 is a side view illustrating the optical layer for a light control type solar photovoltaic module according to this reference example, FIG. 38 is another side view illustrating the optical layer for a light control type solar photovoltaic module according to this reference example, and FIG. 35 is a plan view illustrating the optical layer for a light control type solar photovoltaic module according to this reference example. As illustrated in FIGS. 36 to 39, a number of prismatic optical elements made of square pyramid prisms are formed in an entrance surface 11 of the optical layer for a light control type solar photovoltaic module according to this reference example while a number of prismatic optical elements made of linear prisms are formed in an exit surface 12 thereof. The prismatic optical elements provided in the entrance surface 11 are on a common plane S1, defined by a common base shared by the prismatic optical elements adjacent to each other. Prism axes 7 of some of the prismatic optical elements formed in the entrance surface 11 are inclined toward one direction with respect to a plane perpendicular to the common plane S1 while prism axes 7' of at least some of the other prismatic optical elements are inclined toward the other direction. In this reference example, prism axes 7 and 7' of a pair of prismatic optical elements adjacent to each other are inclined in directions different from each other. Because the side view of FIG. 38 differs from that of FIG. 37, the prism axes 7 and 7' appear to overlap with each other in FIG. 38. On the other hand, the prismatic optical elements formed in the exit surface 12 are on a common plane S2 defined by a common base shared by the prismatic optical elements adjacent to each other, and a prism axis of each prismatic optical element formed in the exit surface 12 corresponds to a perpendicular line drawn from an apex of the optical element to the common plane S2 .

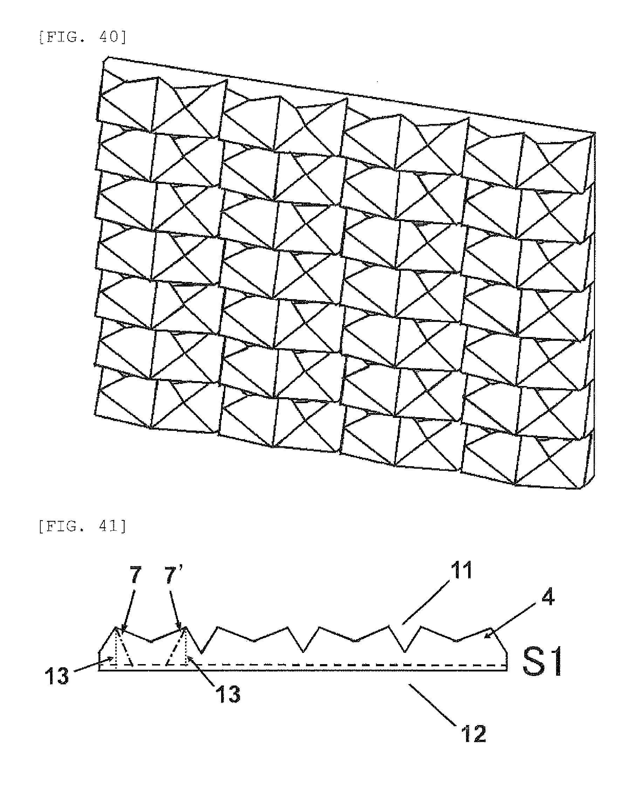

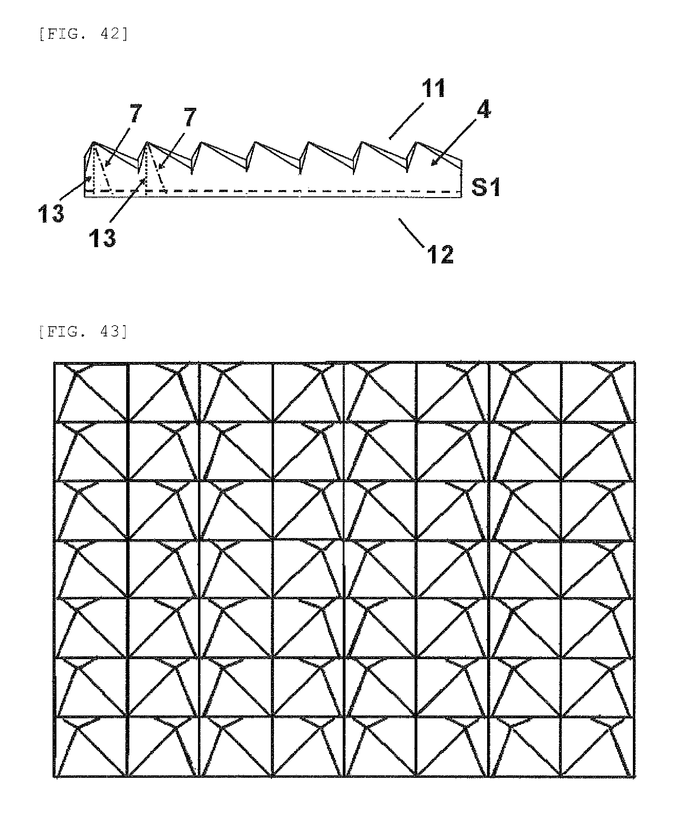

FIGS. 40, 41, 42, and 43 illustrate an optical layer for a light control type solar photovoltaic module according to an embodiment of the invention. Specifically, FIG. 40 is a perspective view illustrating the optical layer of a light control type solar photovoltaic module according to this embodiment, FIG. 41 is a side view illustrating the optical layer for a light control type solar photovoltaic module according to this embodiment, FIG. 42 is another side view illustrating the optical layer for a light control type solar photovoltaic module according to this embodiment, and FIG. 43 is a plan view illustrating the optical layer for a light control type solar photovoltaic module according to this embodiment. As illustrated in FIGS. 40 to 43, a number of prismatic optical elements made of square pyramid prisms are formed in an entrance surface 11 of the optical layer for a light control type solar photovoltaic module of this embodiment while an exit surface thereof is formed flat. The prismatic optical elements provided in the entrance surface 11 are on a common plane S1 defined by a common base shared by the prismatic optical elements adjacent to each other. As illustrated in FIG. 43, prism axes 7 of the prismatic optical elements are inclined laterally and vertically with respect to a line perpendicular to the common plane. In other words, the optical elements on the common plane S1 are inclined in predetermined directions with respect to the direction perpendicular to the common plane S1 and prism axes 7 of some of the prismatic optical elements are inclined toward one direction with respect to the plane perpendicular to the common plane S1 while prism axes 7' of at least some of the other prismatic optical elements are inclined toward the other direction with respect to the plane perpendicular to the common plane S1.

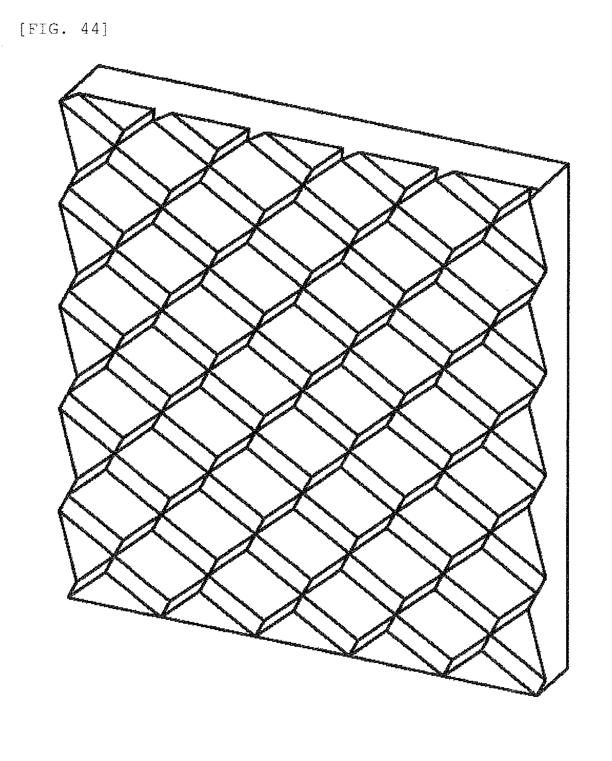

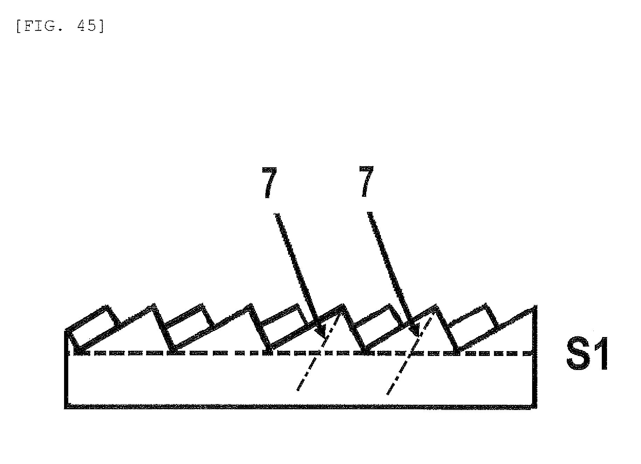

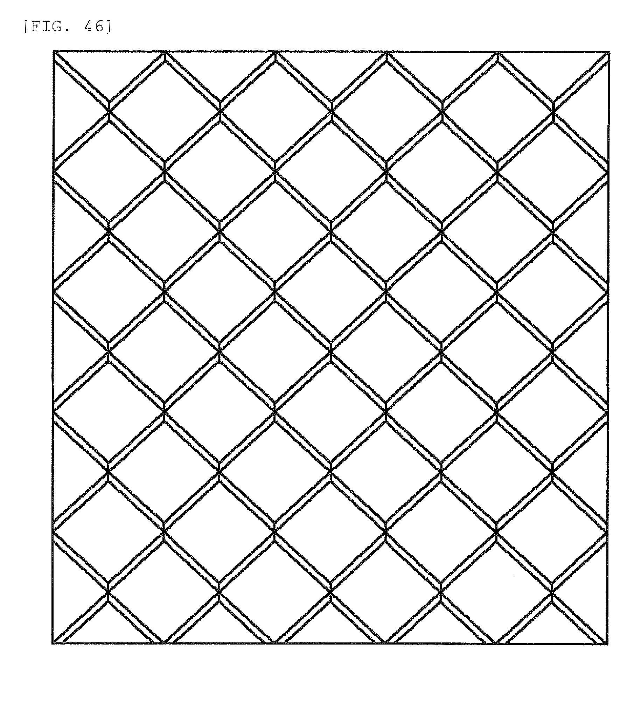

FIGS. 44, 45, and 46 illustrate an optical layer for a light control type solar photovoltaic module according to another embodiment of the invention. Specifically, FIG. 44 is a perspective view illustrating the optical layer for a light control type solar photovoltaic module according to this embodiment, FIG. 45 is a side view illustrating the optical layer for a light control type solar photovoltaic module according to this embodiment, and FIG. 46 is a plan view illustrating the optical layer for a light control type solar photovoltaic module according to this embodiment. As illustrated in FIGS. 44 to 46, a number of prismatic optical elements made of corner cube prisms are formed in an entrance surface 11 of the optical layer for a light control type solar photovoltaic module according to this embodiment while an exit surface thereof is formed flat. The prismatic optical elements formed in the entrance surface 11 are on a common plane S1 defined by a common base shared by the prismatic optical elements adjacent to each other. As illustrated in FIG. 45, prism axes of the prismatic optical elements are inclined in a predetermined direction with respect to a perpendicular line drawn from an apex of each optical element to the common plane. Note that in this embodiment, the prismatic optical elements may be formed such that the prism axes 7 are inclined at different angles in predetermined directions.

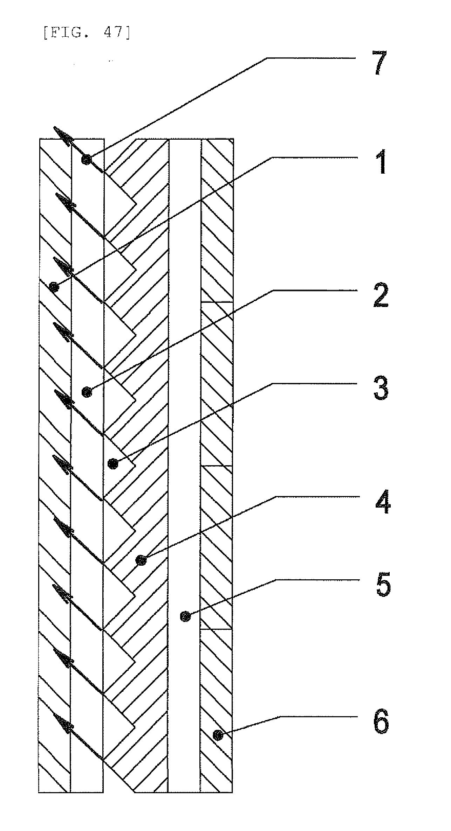

FIG. 47 is a sectional view illustrating a configuration of a solar photovoltaic module constituting a solar photovoltaic panel according to an embodiment of the invention.

In FIG. 47, a layer that protects the surface is denoted by the reference numeral 1. Usually, a glass plate is preferably used as the layer 1. An optical layer according to a conventional technique or an optical layer for a light control type solar photovoltaic module according to a reference example or an embodiment of the invention of those described above is denoted by the reference numeral 4. A number of optical elements are formed in the surface of the optical layer 4. In a case where an optical layer for a light control type solar photovoltaic module according to an embodiment of the invention is used, the optical axes 7 of the prismatic optical elements are designed to be inclined at angles in the range of 10° to 50° with respect to the perpendicular plane. Adhesive layers that bond the surface layer 1, the optical layer 4, and photovoltaic cells 6 are denoted by the reference numerals 2 and 5. In this manner, the optical layer 4 for the light control type solar photovoltaic module is arranged opposite the photovoltaic cells 6. Note that it is not always necessary that the optical layer 4 for the light control type solar photovoltaic module and the photovoltaic cells 6 be arranged opposite each other in parallel to each other, but the optical layer 4 for a light control type solar photovoltaic module and the photovoltaic cells 6 may be arranged opposite each other and non-parallel to each other.

Preferably, an air layer 3 is provided between the optical layer 4 for the light control type solar photovoltaic module and the surface layer 1 in order to improve the optical yield. For example, the air layer 3 may be formed by partially bonding the adhesive layer 2 to form a capsule structure, thereby providing the air layer 3.

The light control type solar photovoltaic panel includes the light control type solar photovoltaic module, and a metallic plate such as aluminum, a back material made of plastic, and a reinforcement frame material that encloses a periphery of the light control type solar photovoltaic module to achieve reinforcement and waterproof can appropriately be provided in order to reinforce the back surface of the light control type solar photovoltaic module.

In a state where the solar photovoltaic panel is installed in the solar direction (the south direction in the northern hemisphere) at noon, the optical axes of the prismatic optical elements of the optical layer 4 for the light control type solar photovoltaic module of the embodiment of the invention can be inclined at angles in the range of -40° to +40° relative to the horizontal direction, and more preferably at angles in the range of - 40° to -5° and/or +5° to +40° relative to the horizontal direction. When such elements whose optical axes are inclined in the east-west direction are used, the sunlight can be received along the optical axes and the photovoltaic cells can be efficiently irradiated with the sunlight even with a solar photovoltaic panel that is installed in the direction out of the south direction.

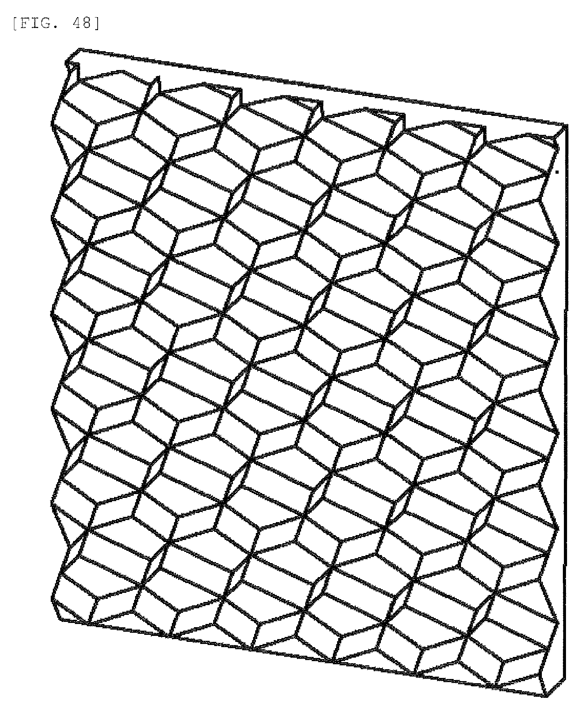

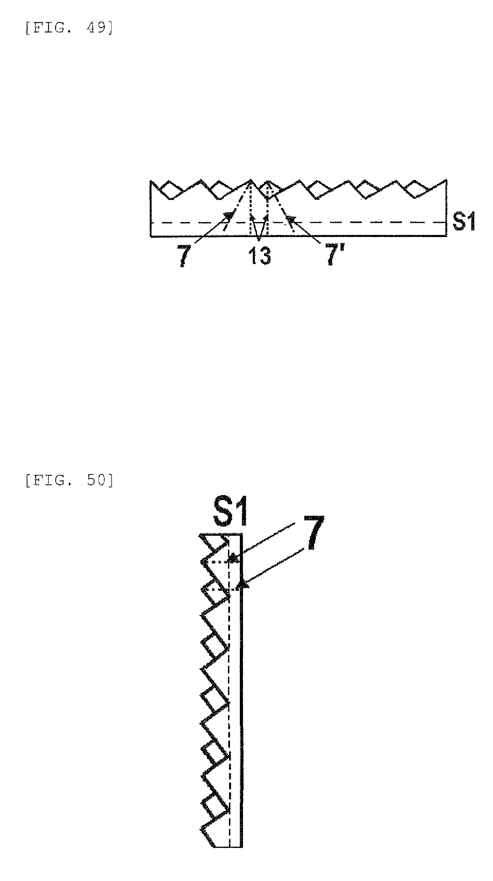

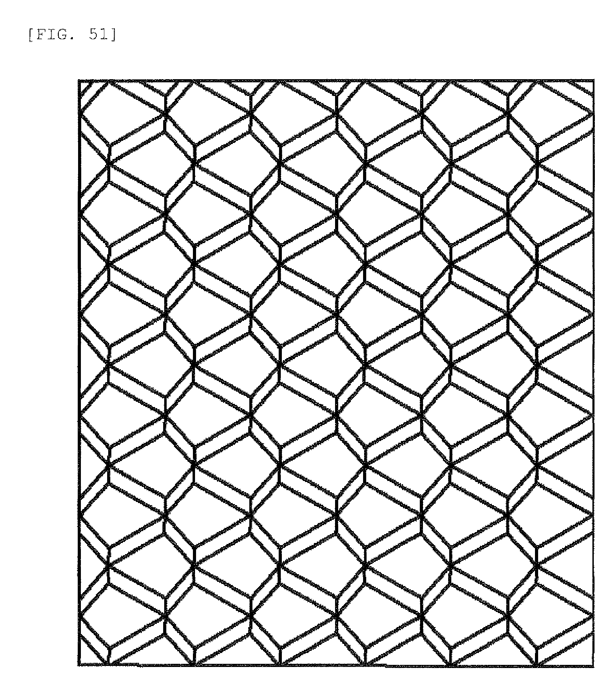

FIGS. 48 to 51 illustrate an optical layer for a light control type solar photovoltaic module according to another embodiment of the invention. Specifically, FIG. 48 is a perspective view illustrating the optical layer for a light control type solar photovoltaic module according to this embodiment, FIG. 49 is a side view illustrating the optical layer for a light control type solar photovoltaic module according to this embodiment, FIG. 50 is another side view illustrating the optical layer for a light control type solar photovoltaic module according to this embodiment, and FIG. 51 is a plan view illustrating the optical layer for a light control type solar photovoltaic module according to this embodiment. As illustrated in FIG. 48, the prismatic optical elements in the optical layer for a light control type solar photovoltaic module are made of so-called cube corner elements having three lateral surfaces (surface a, surface b, and surface c) that are perpendicular to one another, similarly to the prismatic optical elements illustrated in FIG. 44. In this embodiment, pairs of horizontally inclined optical elements indicated by L and R are combined in the prismatic optical elements. The optical axis of an element indicated by L is inclined leftward in the drawing. The optical axis of an element indicated by R is inclined rightward in the drawing.

In a case where a panel surface of a solar photovoltaic panel P, in which the optical layer for a light control type solar photovoltaic module in which the prismatic optical elements illustrated in FIGS. 48 to 51 are formed is used, is oriented in the south direction, a pair of symmetrical prismatic optical elements having optical axes inclined at angles in the range of 5° to 40° toward opposite directions relative to the east-west direction is formed. Therefore, even if the entrance angle of the sunlight changes during the day, the entrance light can be received along the optical axes and the photovoltaic cells can be efficiently irradiated with the sunlight.

Moreover, among the lateral surfaces (surface a, surface b and surface c) that are perpendicular to one another and form an optical element illustrated in FIGS. 48 to 51, the surface a and the surface b have areas smaller than that of the surface c. As a result, similarly to the optical layer for a light control type solar photovoltaic module illustrated in FIGS. 45 and 46, the optical axes of the prismatic optical elements in FIG. 47 are not perpendicular to a common plane parallel to a plane defined by a group of apexes of the prismatic optical elements but are inclined forward in FIG. 47 (toward the surface a and the surface b).

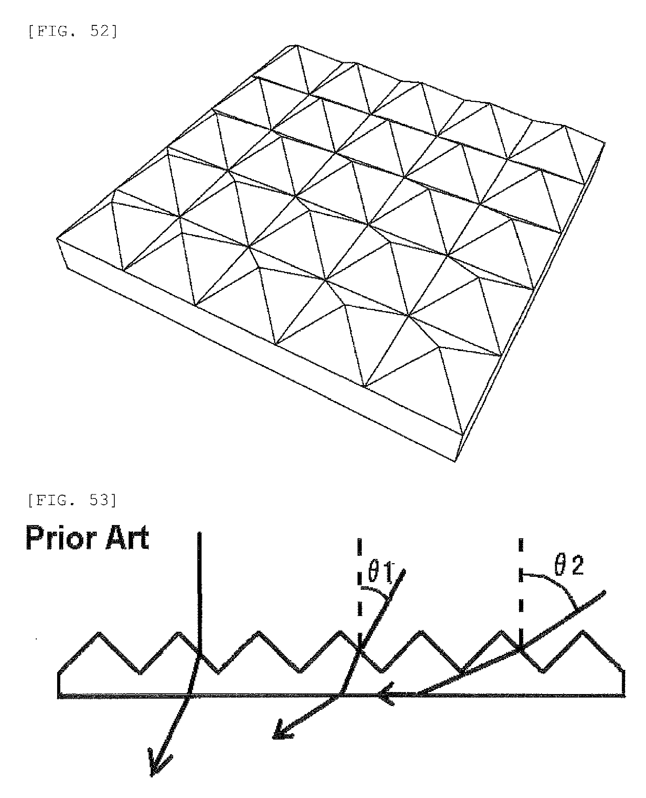

FIG. 52 is a perspective view illustrating optical elements that can be used for a solar photovoltaic panel P according to another embodiment of the invention. The prismatic optical elements in FIG. 52 are called square pyramid prisms. Although the illustrated prismatic optical elements appear to have optical axes perpendicular to a common plane in FIG. 52, the optical axes are actually inclined at angles in a range of 10° to 50° relative to the vertical line similarly to the optical elements illustrated in FIG. 9. When the prismatic optical elements in FIG. 52 are applied to the light control type solar photovoltaic panel including the solar photovoltaic module illustrated in FIG. 47, it is preferable that symmetrical optical elements, inclined at angles in a range of 5° to 40° relative to the east-west direction, be formed as a pair.

Next, a state in which light is transmitted through an optical layer will be described.

FIG. 53 is a view illustrating a state in which light is transmitted through the optical layer according to the conventional technique illustrated in FIGS. 7 to 9 and FIGS. 28 to 31. As illustrated in FIG. 53, light incident perpendicularly to the optical layer tends to exit in a state inclined with respect to the optical layer. Light incident to the optical layer at a relatively small angle θ1 with respect to the direction perpendicular to the optical layer tends to exit at an angle larger than the angle θ1 with respect to the direction perpendicular to the optical layer. Light incident to the optical layer at a relatively large angle θ2 with respect to the direction perpendicular to the optical layer may be subjected to total internal reflection at the exit surface and may not exit. Accordingly, if such an optical layer is applied to the solar photovoltaic module illustrated in FIG. 47, the entrance efficiency of light incident to the photovoltaic cells is degraded.

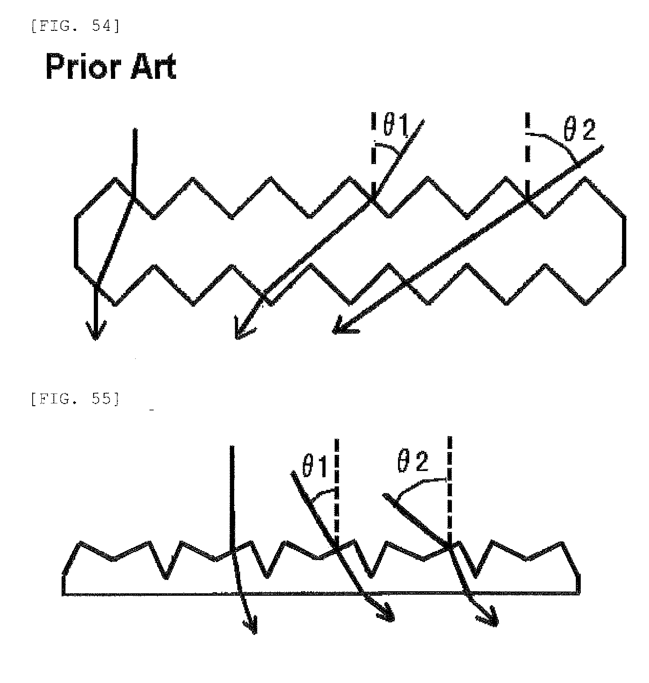

FIG. 54 is a view illustrating a state in which light is transmitted through the optical layer according to the conventional technique illustrated in FIGS. 10 to 12. As illustrated in FIG. 54, light incident perpendicularly to the optical layer tends to exit in a direction perpendicular to the optical layer. Both of light incident to the optical layer at the relatively small angle θ1 with respect to the direction perpendicular to the optical layer and light incident to the optical layer at the relatively large angle θ2 with respect to the direction perpendicular to the optical layer tend to exit in the direction parallel to the incident light. Accordingly, even if such an optical layer is applied to the solar photovoltaic module illustrated in FIG. 47, the entrance efficiency of light incident to the photovoltaic cells tends to be hardly improved.

FIG. 55 is a view illustrating a state in which light is transmitted through the optical layer for a light control type solar photovoltaic module according to the reference example illustrated in FIGS. 13 to 15. As illustrated in FIG. 55, light that is incident in the direction perpendicular to the optical layer for a light control type solar photovoltaic module exits in a state slightly inclined with respect to the direction perpendicular to the optical layer for a light control type solar photovoltaic module, and light that is incident at the relatively small angle θ1 with respect to the direction perpendicular to the optical layer for a light control type solar photovoltaic module exits at an angle larger than the angle θ1 with respect to the direction perpendicular to the optical layer for a light control type solar photovoltaic module. However, light that is incident at the relatively large angle θ2 with respect to the direction perpendicular to the optical layer for a light control type solar photovoltaic module can exit through the exit surface. Accordingly, by applying such an optical layer for a light control type solar photovoltaic module to the solar photovoltaic module illustrated in FIG. 47, the entrance efficiency of light incident to the photovoltaic cells can be improved even if light having a large angle with respect to the direction perpendicular to the optical layer for a light control type solar photovoltaic module is incident, and an excellent directionality to the sunlight can be obtained even if the entrance angle of the sunlight changes with the movement of the sun.

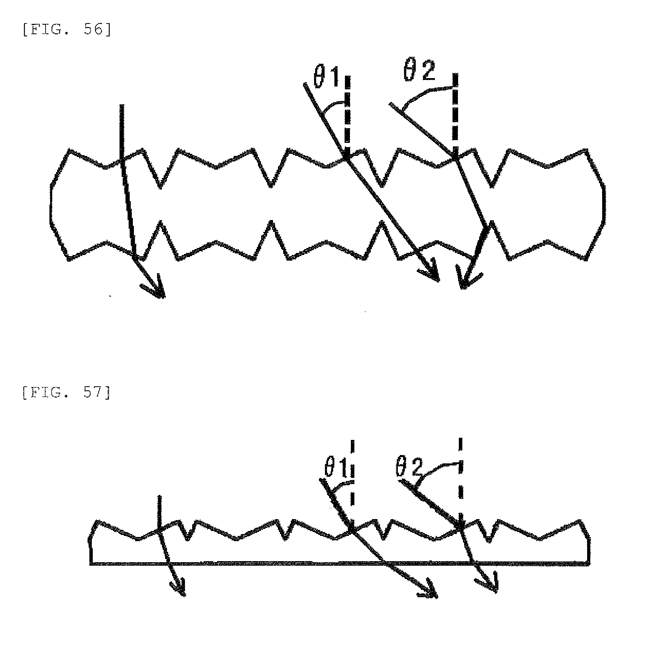

FIG. 56 is a view illustrating a state in which light is transmitted through the optical layer for a light control type solar photovoltaic module according to the reference example illustrated in FIGS. 16 to 18. As illustrated in FIG. 56, light that is incident in the direction perpendicular to the optical layer for a light control type solar photovoltaic module exits in a state slightly inclined with respect to the direction perpendicular to the optical layer for a light control type solar photovoltaic module, and light that is incident at the relatively small angle θ1 with respect to the direction perpendicular to the optical layer for a light control type solar photovoltaic module exits at an angle larger than the angle θ1 with respect to the direction perpendicular to the optical layer for a light control type solar photovoltaic module. However, light that is incident at the relatively large angle θ2 with respect to the direction perpendicular to the optical layer for a light control type solar photovoltaic module can exit through the exit surface. Accordingly, by applying such an optical layer for a light control type solar photovoltaic module to the solar photovoltaic module illustrated in FIG. 47, the entrance efficiency of light incident to the photovoltaic cells can be improved even if light having a large angle with respect to the direction perpendicular to the optical layer for a light control type solar photovoltaic module is incident, and an excellent directionality to the sunlight can be obtained even if the entrance angle of the sunlight changes with the movement of the sun.

FIG. 57 is a view illustrating a state in which light is transmitted through the optical layer for a light control type solar photovoltaic module according to the reference example illustrated in FIGS. 19 to 21. As illustrated in FIG. 57, light that is incident in the direction perpendicular to the optical layer for a light control type solar photovoltaic module exits in a state slightly inclined with respect to the direction perpendicular to the optical layer for a light control type solar photovoltaic module, and light that is incident at the relatively small angle θ1 with respect to the direction perpendicular to the optical layer for a light control type solar photovoltaic module exits at an angle larger than the angle θ1 with respect to the direction perpendicular to the optical layer for a light control type solar photovoltaic module. However, light that is incident at the relatively large angle θ2 with respect to the direction perpendicular to the optical layer for a light control type solar photovoltaic module can exit through the exit surface. Accordingly, by applying such an optical layer for a light control type solar photovoltaic module to the solar photovoltaic module illustrated in FIG. 47, the entrance efficiency of light incident to the photovoltaic cells can be improved even if light having a large angle with respect to the direction perpendicular to the optical layer for a light control type solar photovoltaic module is incident, and an excellent directionality to the sunlight can be obtained even if the entrance angle of the sunlight changes with the movement of the sun.

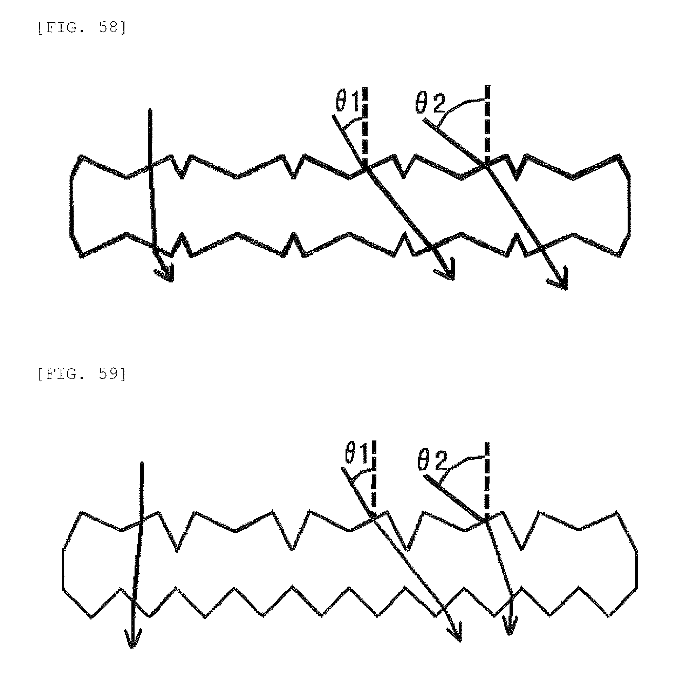

FIG. 58 is a view illustrating a state in which light is transmitted through the optical layer for a light control type solar photovoltaic module according to the reference example illustrated in FIGS. 22 to 24. As illustrated in FIG. 58, light that is incident in the direction perpendicular to the optical layer for a light control type solar photovoltaic module exits in a state slightly inclined with respect to the direction perpendicular to the optical layer for a light control type solar photovoltaic module, and light that is incident at the relatively small angle θ1 with respect to the direction perpendicular to the optical layer for a light control type solar photovoltaic module exits at an angle larger than the angle θ1 with respect to the direction perpendicular to the optical layer for a light control type solar photovoltaic module. However, light that is incident at the relatively large angle θ2 with respect to the direction perpendicular to the optical layer for a light control type solar photovoltaic module can exit through the exit surface. Accordingly, by applying such an optical layer for a light control type solar photovoltaic module to the solar photovoltaic module illustrated in FIG. 47, the entrance efficiency of light incident to the photovoltaic cells can be improved even if light having a large angle with respect to the direction perpendicular to the optical layer for a light control type solar photovoltaic module is incident, and an excellent directionality to the sunlight can be obtained even if the entrance angle of the sunlight changes with the movement of the sun.

FIG. 59 is a view illustrating a state in which light is transmitted through the optical layer for a light control type solar photovoltaic module according to the reference example illustrated in FIGS. 25 to 27. As illustrated in FIG. 59, light that is incident in the direction perpendicular to the optical layer for a light control type solar photovoltaic module exits in a direction substantially perpendicular to the optical layer for a light control type solar photovoltaic module. Light that is incident at the relatively small angle θ1 with respect to the direction perpendicular to the optical layer for a light control type solar photovoltaic module exits at an angle larger than the angle θ1 with respect to the direction perpendicular to the optical layer for a light control type solar photovoltaic module. However, light that is incident at the relatively large angle θ2 with respect to the direction perpendicular to the optical layer for a light control type solar photovoltaic module can exit through the exit surface. Accordingly, by applying such an optical layer for a light control type solar photovoltaic module to the solar photovoltaic module illustrated in FIG. 47, the entrance efficiency of light incident to the photovoltaic cells can be improved and the exit direction of the sunlight incident at an angle with respect to the direction perpendicular to the optical layer for a light control type solar photovoltaic module can be improved even if light having a large angle with respect to the direction perpendicular to the optical layer for a light control type solar photovoltaic module is incident. Accordingly, an excellent directionality to the sunlight can be obtained even if the entrance angle of the sunlight changes with the movement of the sun.

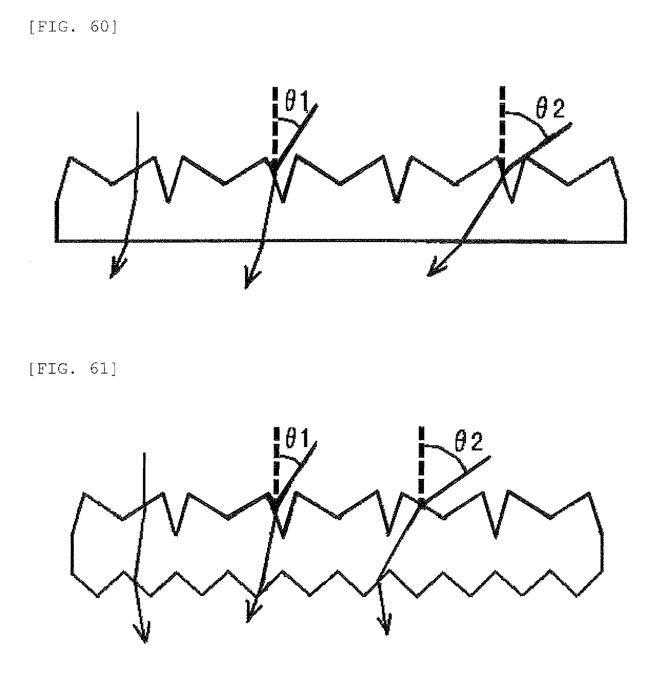

FIG. 60 is a view illustrating a state in which light is transmitted through the optical layer for a light control type solar photovoltaic module according to the reference example illustrated in FIGS. 32 to 35. As illustrated in FIG. 60, although light that is incident in the direction perpendicular to the optical layer for a light control type solar photovoltaic module exits in a state slightly inclined with respect to the direction perpendicular to the optical layer for a light control type solar photovoltaic module, both of light that is incident at the relatively small angle θ1 and light that is incident at the relatively large angle θ2 with respect to the direction perpendicular to the optical layer for a light control type solar photovoltaic module can exit through the exit surface at improved exit angles compared with the angles θ1 and θ2. Accordingly, by applying such an optical layer for a light control type solar photovoltaic module to the solar photovoltaic module illustrated in FIG. 47, the entrance efficiency of light incident to the photovoltaic cells can be improved even if light having a large angle with respect to the direction perpendicular to the optical layer for a light control type solar photovoltaic module is incident, and an excellent directionality to the sunlight can be obtained even if the entrance angle of the sunlight changes with the movement of the sun.

Fig. 61 is a view illustrating a state in which light is transmitted through the optical layer for a light control type solar photovoltaic module according to the reference example illustrated in FIGS. 36 to 39. As illustrated in FIG. 61, light that is incident in the direction perpendicular to the optical layer for a light control type solar photovoltaic module exits in the direction substantially perpendicular to the optical layer for a light control type solar photovoltaic module, and light that is incident at the relatively small angle θ1 and light that is incident at the relatively large angle θ2 with respect to the direction perpendicular to the optical layer for a light control type solar photovoltaic module exit through the exit surface at angles that are closer to the perpendicularity than the angle θ1 and the angle θ2 at which the lights are incident, respectively. Accordingly, by applying such an optical layer for a light control type solar photovoltaic module to the solar photovoltaic module illustrated in FIG. 47, the entrance efficiency of light incident to the photovoltaic cells can be improved and the exit direction of the sunlight incident at an angle with respect to the direction perpendicular to the optical layer for a light control type solar photovoltaic module can be improved even if light having a large angle with respect to the direction perpendicular to the optical layer for a light control type solar photovoltaic module is incident. Accordingly, an excellent directionality to the sunlight can be obtained even if the entrance angle of the sunlight changes with the movement of the sun.

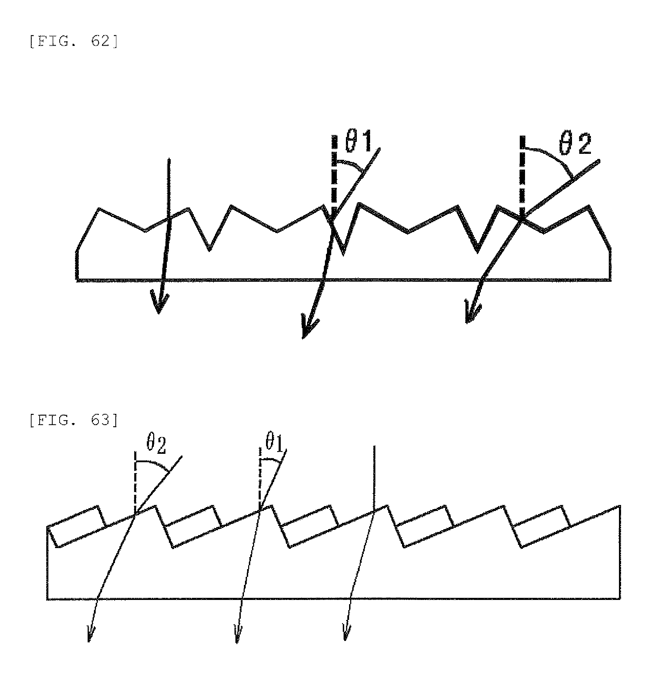

FIG. 62 is a view illustrating a state in which light is transmitted through the optical layer for a light control type solar photovoltaic module according to the embodiment of the invention illustrated in FIGS. 40 to 43. As illustrated in FIG. 62, although light that is incident in the direction perpendicular to the optical layer for a light control type solar photovoltaic module exits in a state slightly inclined with respect to the direction perpendicular to the optical layer for a light control type solar photovoltaic module, both of light that is incident at the relatively small angle θ1 and light that is incident at the relatively large angle θ2 with respect to the direction perpendicular to the optical layer for a light control type solar photovoltaic module exit through the exit surface at angles that are closer to the perpendicularity than the angle θ1 and the angle θ2 at which the lights are incident, respectively. Accordingly, by applying such an optical layer for a light control type solar photovoltaic module to the solar photovoltaic module illustrated in FIG. 47, the entrance efficiency of light incident to the photovoltaic cells can be improved even if light having a large angle with respect to the direction perpendicular to the optical layer for a light control type solar photovoltaic module is incident, and an excellent directionality to the sunlight can be obtained even if the entrance angle of the sunlight changes with the movement of the sun.

FIG. 63 is a view illustrating a state in which light is transmitted through the optical layer for a light control type solar photovoltaic module according to another embodiment of the invention illustrated in FIGS. 44 to 46. As illustrated in FIG. 63, light that is incident in the direction perpendicular to the optical layer for a light control type solar photovoltaic module exits in a state slightly inclined with respect to the direction perpendicular to the optical layer for a light control type solar photovoltaic module. However, light that is incident at the relatively small angle θ1 and light that is incident at the relatively large angle θ2 with respect to a predetermined direction in which the prismatic optical elements of the optical layer for a light control type solar photovoltaic module are inclined exit through the exit surface at angles that are closer to the perpendicularity than the angle θ1 and the angle θ2 at which the lights are incident, respectively. Accordingly, by applying such an optical layer for a light control type solar photovoltaic module to the solar photovoltaic module illustrated in FIG. 47, an excellent directionality to the sunlight can be obtained with respect to the sunlight that is incident in the predetermined direction in which the prismatic optical elements are inclined. Therefore, by installing a solar photovoltaic panel in which the optical layer for a light control type solar photovoltaic module is used in a state in which the prismatic optical elements are arranged in an inclined state to face upward, the solar photovoltaic panel can have an excellent directionality to the sunlight.

Although not illustrated in FIG. 62, in a state in which light is transmitted in the side view of FIG. 43, both of light that is incident at the relatively small angle and light that is incident at the relatively large angle with respect to the predetermined direction in which the prismatic optical elements of the optical layer for a light control type solar photovoltaic module are inclined can exit through the exit surface. Accordingly, by applying such an optical layer for a light control type solar photovoltaic module to the solar photovoltaic module illustrated in FIG. 47, an excellent directionality to the sunlight can be obtained with respect to the sunlight that is incident in the predetermined direction in which the prismatic optical elements are inclined. Therefore, by installing a solar photovoltaic panel in which the optical layer for a light control type solar photovoltaic module is used in a state in which the prismatic optical elements are arranged upward, the solar photovoltaic panel can have an excellent directionality to the sunlight.

### Industrial Applicability

The invention relates to a technique for a light control type solar photovoltaic panel and a light control type solar photovoltaic module preferably used therein, more specifically to a light control optical layer constituting the light control type solar photovoltaic module.

More particularly, the invention relates to a light control type solar photovoltaic panel having improved directionality to the sunlight and improved installation area.

The invention also relates to a light control type solar photovoltaic panel that can reduce the use amount of the photovoltaic cells accounting for a large proportion of raw material cost in the solar photovoltaic panel.

### Description of Reference Numerals

- 1: surface layer
- 2, 5: adhesive layer
- 3: air layer
- 4: optical element layer (optical layer for a light control type solar photovoltaic module)
- 6: photovoltaic cell
- 7, 7': prism axis
- 8, 8': prism axis
- 11: entrance surface
- 12: exit surface
- 13, 14: direction perpendicular to common plane
- P: solar photovoltaic panel
- S1, S2: common plane

## Claims

1. An optical layer for a light control type solar photovoltaic module including an entrance surface and an exit surface and being arranged opposite a photovoltaic cell that converts light into electric energy, wherein
a number of prismatic optical elements are formed in at least one of the entrance surface and the exit surface,
each of the prismatic optical elements is on a common plane defined by a common base shared by the prismatic optical elements adjacent to each other, and
a prism axis of each of the prismatic optical elements is inclined toward a predetermined direction with respect to a direction perpendicular to the common plane.

2. The optical layer for a light control type solar photovoltaic module according to claim 1, wherein a number of prismatic optical elements are formed such that prism axes thereof are inclined toward a predetermined direction at a plurality of angles.

3. The optical layer for a light control type solar photovoltaic module according to claim 1 or 2, wherein the prismatic optical elements are one of linear prisms, triangular pyramid prisms, square pyramid prisms, and a cube corner prisms or a combination thereof.

4. The optical layer for a light control type solar photovoltaic module according to any one of claims 1 to 3, wherein bases of all the prismatic optical elements are formed on the common plane.

5. The optical layer for a light control type solar photovoltaic module according to any one of claims 1 to 3, wherein some bases of the prismatic optical elements are formed out of the common plane.

6. The optical layer for a light control type solar photovoltaic module according to any one of claims 1 to 5, wherein the prismatic optical elements are formed in both the entrance surface and the exit surface.

7. The optical layer for a light control type solar photovoltaic module according to claim 6, wherein the prismatic optical elements are formed such that the prismatic optical elements formed in the entrance surface and the prismatic optical elements formed in the exit surface have identical shapes and such that phases of the prismatic optical elements are matched with each other between the entrance surface and the exit surface.

8. The optical layer for a light control type solar photovoltaic module according to claim 6, wherein the prism axes of the prismatic optical elements formed in the entrance surface differ in shape from the prism axes of the prismatic optical elements formed in the exit surface.

9. The optical layer for a light control type solar photovoltaic module according to any one of claims 1 to 5, wherein the prismatic optical elements are formed only in one of the entrance surface and the exit surface while the other surface is formed flat.

10. The optical layer for a light control type solar photovoltaic module according to any one of claims 1 to 9, wherein the optical layer for a light control type solar photovoltaic module is made of glass, transparent resin, or a laminated body thereof.

11. A light control type solar photovoltaic module comprising:
a photovoltaic cell that converts light into electric energy; and
an optical layer for a light control type solar photovoltaic module that includes an entrance surface and an exit surface and is arranged opposite the photovoltaic cell, wherein
in the optical layer for a light control type solar photovoltaic module,
a number of prismatic optical elements are formed in at least one of the entrance surface and the exit surface,
each of the prismatic optical elements is on a common plane defined by an element base plane, the element base plane being defined by a common base shared by the prismatic optical elements adjacent to each other, and
a prism axis of each of the prismatic optical elements is inclined toward a predetermined direction with respect to a direction perpendicular to the common plane.

12. A light control type solar photovoltaic panel comprising:
a light control type solar photovoltaic module including a photovoltaic cell that converts light into electric energy and an optical layer for a light control type solar photovoltaic module that includes an entrance surface and an exit surface and is arranged opposite the photovoltaic cell, wherein
in the optical layer for a light control type solar photovoltaic module,
a number of prismatic optical elements are formed in at least one of the entrance surface and the exit surface,
each of the prismatic optical elements is on a common plane defined by an element base plane, the element base plane being defined by a common base shared by the prismatic optical elements adjacent to each other, and
a prism axis of each of the prismatic optical elements is inclined toward a predetermined direction with respect to a direction perpendicular to the common plane.

13. The light control type solar photovoltaic panel according to claim 12, wherein the entrance surface of the optical layer for a light control type solar photovoltaic module is oriented to a sun direction at noon.

14. The light control type solar photovoltaic panel according to claim 13, wherein the entrance surface of the optical layer for a light control type solar photovoltaic module is inclined at an angle in a range of 0 to 20° with respect to a vertical line.

15. The light control type solar photovoltaic panel according to claim 13 or 14, wherein the prism axis in an installed state is inclined at an angle in a range of +10 to +50° with respect to a vertical direction.

16. The light control type solar photovoltaic panel according to claim 15, wherein a number of prismatic optical elements are formed such that prism axes thereof are inclined toward a predetermined direction at a plurality of angles.
